# EUROPÄISCHE PATENTSCHRIFT

(11) **EP 2 923 261 B1**
(45) Veröffentlichungstag und Bekanntmachung des Hinweises auf die Patenterteilung: **08.03.2023**
(21) Anmeldenummer: 13798568.5
(22) Anmeldetag: 15.11.2013
(51) Int. Cl.: G06F 3/06

(54) **VERFAHREN ZUR STEUERUNG EINES FLASH-SPEICHERS ZUR MASSENSPEICHERUNG, DER VON EINEM AN EINEN HOST ANSCHLIEßBAREN KOMMUNIKATIONSGERÄT UMFASST IST, UND COMPUTERPROGRAMMPRODUKT ZUR AUSFÜHRUNG DES VERFAHRENS**
METHOD FOR CONTROLLING A FLASH MEMORY FOR MASS STORAGE, WHICH IS COMPRISED BY A COMMUNICATIONS DEVICE THAT CAN BE CONNECTED TO A HOST, AND COMPUTER PROGRAM PRODUCT FOR CARRYING OUT SAID METHOD
PROCÉDÉ DE COMMANDE D'UNE MÉMOIRE FLASH, DESTINÉE AU STOCKAGE DE MASSE, INCORPORÉE DANS UN APPAREIL DE COMMUNICATION CONNECTABLE À UN HÔTE, ET PRODUIT PROGRAMME D'ORDINATEUR POUR EXÉCUTER CE PROCÉDÉ

(30) Priorität: 21.11.2012 DE 102012022728
(43) Veröffentlichungstag der Anmeldung: 30.09.2015
(73) Patentinhaber: Unify GmbH & Co. KG, 81739 München (DE)
(72) Erfinder: ROSTOCK, Lars, 85604 Zorneding (DE)
(74) Vertreter: Schaafhausen Patentanwälte PartGmbB
(86) Internationale Anmeldenummer: PCT/EP2013/003447
(87) Internationale Veröffentlichungsnummer: WO 2014/079550

(56) Entgegenhaltungen:
- GB-A- 2 251 323
- GB-A- 2 251 324
- US-A- 5 559 988
- US-A- 5 802 343
- US-A1- 2007 061 504
- US-A1- 2012 224 439

## Beschreibung

Die Erfindung betrifft ein Verfahren zur Steuerung eines Flash-Speichers, der von einem Kommunikationsgerät, das an einen Host anschließbar ist, umfasst ist und zur Massenspeicherung mit zu speichernden Daten beschrieben wird. Die Erfindung betrifft ferner ein Computerprogrammprodukt zum Ausführen eines solchen Verfahrens.

Massenspeicher findet man als USB-Memory-Stick (USB: Universal Serial Bus), Speicherkarten, z. B. für digitale Fotokameras, Mobiltelefone oder Multi-Media-Abspielgeräte oder in Form einer SSD (SSD: Solid State Disk). Ein Massenspeicher umfasst eine Einheit mit der Funktion eines Speichercontrollers und einen oder mehrere nicht flüchtige Speicherbausteine. Als Speicherbausteine können sogenannte Flash-EEPROM-Halbleiterspeicher (Electrically Erasable Programmable Read-Only Memory) eingesetzt werden, die keine Spannungsquelle benötigen, um gespeicherte Information aufrechtzuerhalten. Es gibt verschiedene Flash-Typen, die nach der Architektur und dem eingesetzten Speicherverfahren unterschieden werden. Unter Architektur wird im Folgenden die Anordnung von Speicherzellen im Speicherbaustein verstanden. Unter dem eingesetzten Speicherverfahren wird im Folgenden die Anzahl der zur Speicherung verwendeten Spannungsniveaus innerhalb einer Speicherzelle verstanden. Beispiele von Flash-Typen sind NOR-Flash, NAND-SLC (Single Level Cell) oder NAND-MLC (Multi Level Cell).

Um Daten in die Flash-Speicherbausteine, auch Flash-Speicher genannt, schreiben zu können, müssen die zu beschreibenden Speichereinheiten im Speicherbaustein vorher gelöscht worden sein. Das Löschen der einzelnen Speichereinheiten, die jeweils mindestens eine Speicherzelle zum Speichern eines Bits, das den logischen Wert "0" oder "1" aufweisen kann, umfassen, ist stets nur in im Vergleich zum Schreiben größeren Bereichen, sogenannten Blöcken, auch Erase-Blocks genannt, möglich. Ein Block wird im Folgenden definiert als kleinste Menge an Bytes im Flash-Speicher, die nur gemeinsam gelöscht werden kann. Ein Block umfasst 2^{z} Bytes (z > 13). Typische Blockgrößen zum Speichern von Daten in kByte sind 8, 16, 32, 64, 128 oder 256 kB. Die im Vergleich zu einem Block kleinere Einheit beim Schreiben oder Beschreiben von Speicherzellen des Flash-Speichers, auch Schreibeinheit oder Page genannt, ist definiert als kleinste Menge an Bytes im Flash-Speicher, die nur gemeinsam geschrieben werden kann. Die Größe der Blöcke, auch Löscheinheiten genannt, und der Schreibeinheiten, hängt vom Flash-EEPROM-Typ und von dessen Größe ab. Ein NOR-Flash weist Blockgrößen zwischen 8 kB und 256 kB, typisch 64 kB, auf, wobei eine Schreibeinheit 1 Byte beträgt. Kleinere NAND-Flash-Speicher sind mit einer Blockgröße von 16 kB bei einer Schreibeinheit von einer Page mit 512 Byte erhältlich. Größere NAND-Flash-Speicher mit 128, 512 oder 2048 kB Blockgröße verwenden Pages mit einer (Page-)Größe von 2, 4, oder 8 kB. Die maximal mögliche Anzahl von Lösch- und Schreiboperationen pro Einheit ist technisch bedingt begrenzt und abhängig vom Typ des Flash-Speichers. Durch das Löschen werden die einzelnen Bits im Speicherbaustein auf den Wert "1" gesetzt, wobei durch Schreiben die Bits auf den Wert "0" gesetzt werden. Um eine gleichmäßige "Abnutzung" und Lebensdauer der einzelnen Speicherstellen zu erreichen, werden sämtliche Bits vor dem Löschen auf den Wert "0" programmiert, um dann beim Löschen auf den Wert "1" gesetzt zu werden. So lassen sich kleinere NAND-Flash-Speicher in Schreibeinheiten mit 512 Byte beschreiben, jedoch nur in Blöcken zu 16.384 Bytes (16 kB) löschen. Die vom Host oder Host-System beim Schreiben verwendete kleinste Menge an Daten richtet sich nach der Größe eines Sektors, der definiert ist als die kleinste Einheit, die in einem Dateisystem, auch File-System genannt, eines Hostes oder Host-Systems gemeinsam verarbeitet wird. Ein Arbeitsspeicher und/oder Flash-Speicher ist zumindest prinzipiell in der Lage einen Teilbereich dieser kleinsten Einheit eines Sektors zu verarbeiten. Sektoren umfassen Speichergrößen von 2^{z} Bytes mit z > 3, typischerweise 512 Bytes. Wenn man mit Flash-Speichern einen USB-Massenspeichergerät, wie einen USB-Memory-Stick, realisieren möchte, stößt man auf das o. g. Problem unsymmetrischer Speichergrößen für das Löschen und das Schreiben, da gängige Dateisysteme, wie FAT (File Allocation Table), FAT32 etc. Sektoren mit 512 Byte Größe, die der Größe der Schreibeinheit eines kleineren NAND-Flash-Speichers entspricht, verwenden.

Für eine gleichmäßige Verteilung der Lösch- und Schreiboperationen über alle Blöcke verfügen aufwendige Speichercontroller nicht nur über Steuerkapazitäten zum Steuern der notwendigen Lösch- und Schreiboperationen. Stattdessen weisen diese Speichercontroller Steuerkapazitäten zum Lesen, Löschen und Schreiben von Daten in die für diese Daten passenden Einheiten einschließlich einer Fehlerkorrektur, zum gleichmäßigen Verteilen der Lösch- und Schreiboperationen über sämtliche Blöcke im Speicherbaustein (sogenanntes Wear-Leveling), zum Verwalten von defekten Blöcken und gegebenenfalls ein Verfahren zur "Auffrischung" der gespeicherten Daten auf. In diesem Fall benötigt der Speichercontroller zur Umsetzung der vorgenannten Vorgänge eine Tabelle, mit der die an einer Schnittstelle des Speichercontrollers zu einem Host adressierten logischen Einheiten und die im Flash-Speicher verwendeten physischen Einheiten, verwaltet und verknüpft werden. Bei noch komplexeren Speichercontrollern werden zusätzliche Informationen aus höheren Schichten gemäß dem OSI-7-Schichtmodell (Open Systems Interconnection Reference Model), beispielsweise von dem in dem Host verwendeten Dateisystem, zur Steuerung des Speichercontrollers verwendet. Zum Beispiel informiert der Host den Speichercontroller über das mögliche Löschen von logischen Datenblöcken mittels eines speziellen Kommandos (TRIM-Kommando, siehe WO 2012/062233).

Sofern die Menge an zu speichernden Daten und die Häufigkeit von deren Aktualisierung geringer ist, als dies bei Hauptanwendungen von Massenspeichern der Fall ist, beispielsweise bei Verwendung eines Flash-Speichers als Nebenaggregat eines an den Host anschließbaren Kommunikationsgerätes zur Massenspeicherung von Daten, kann die Funktion des Massenspeichers vereinfacht implementiert werden. In diesem Fall kann auf den separaten Speichercontroller des Massenspeichers mit den vorgenannten aufwendigen Steuerungsverfahren und einer Tabelle, die die adressierten logischen Einheiten an der Schnittstelle zum Host mit den im Flash-Speicher verwendeten physischen Einheiten zu verknüpfen sind, verzichtet werden.

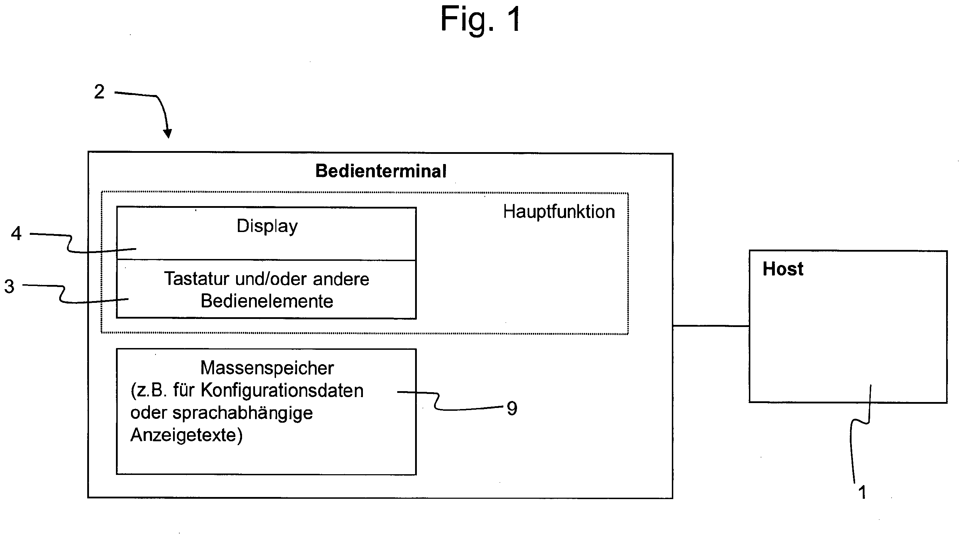

In Fig. 1 ist ein Kommunikationsgerät 2 dargestellt, das an einen Host 1 angeschlossen ist und bei dem ein Flash-Speicher 9 als Massenspeicher nicht als Hauptaggregat zur Speicherung von Daten verwendet wird, sondern als Nebenaggregat. Das Kommunikationsgerät weist ein Bedienterminal in Form einer Tastatur 3 auf, wobei einem Benutzer anzuzeigende Betriebszustände des Kommunikationsgerätes 2 auf einem Display 4 angezeigt werden. Die Eingabe von Befehlen über die Tastatur und/oder andere Bedienelemente sowie die Darstellung des Betriebszustandes des Kommunikationsgerätes 2 in dem Display 4 stellen die Hauptfunktion des Kommunikationsgerätes 2 dar. Der Flash-Speicher 9 wird bei dem Kommunikationsgerät 2 beispielsweise verwendet, um Konfigurationsdaten abzuspeichern und/oder sprachabhängige Texte, die auf dem Display 4 angezeigt werden sollen, abzulegen. Beispielsweise können in dem Flash-Speicher 9 Anzeigetexte in unterschiedlichen Sprachen, z. B. Deutsch, Englisch, Französisch etc. für sich entsprechende Ausgabetexte hinterlegt sein, wobei ein Benutzer bei einer Konfiguration des Kommunikationsgerätes 2 eine bestimmte Sprache, beispielsweise Deutsch, auswählt. Die Anzeigetexte zu den Sprachen, die nicht Deutsch umfassen, sind dann in dem Flash-Speicher 9 als Massenspeicher abgelegt, obwohl diese nach der Konfiguration nicht verwendet werden.

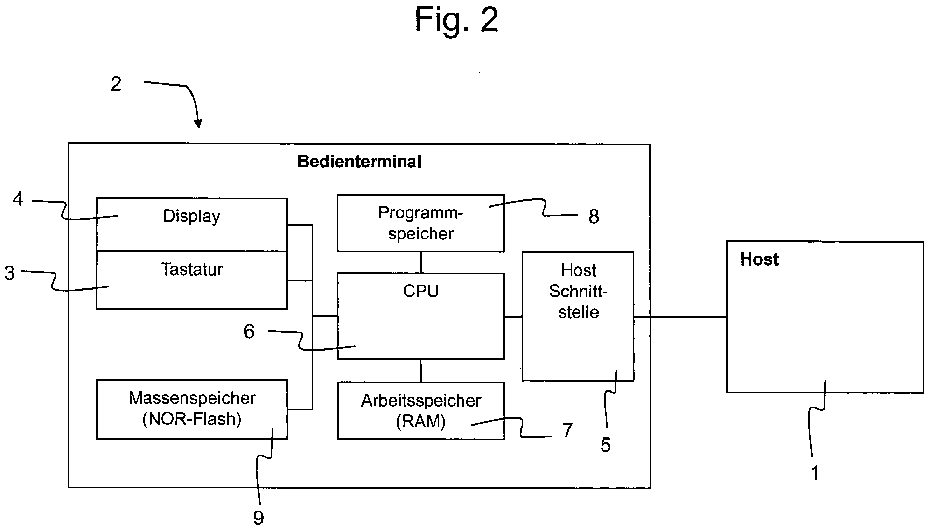

In Fig. 2 ist eine vereinfachte Implementierung der Funktion eines Massenspeichers dargestellt. Der Flash-Speicher 9 "NOR-Flash" weist keinen eigenen Speichercontroller auf, sondern wird über einen Hauptprozessor 6, auch CPU (Central Processing Unit) genannt, mit verwaltet. Der Hauptprozessor 6 nimmt für den Flash-Speicher 9 vorgesehene Befehle von dem Host 1 entgegen und führt Lese-, Schreib- oder Löschoperationen aus. Zur Herstellung der Arbeitsfähigkeit des Hauptprozessors 6 ist dieser an einen Programmspeicher 8 und einen Arbeitsspeicher 7, beispielsweise ein RAM (Random Access Memory) angeschlossen. Das Display 4 ist wie die Tastatur 3 mit dem Hauptprozessor 6 verbunden. Der Host 1 ist mit dem Hauptprozessor 6 über eine Host-Schnittstelle 5 verbunden, die bei dem Kommunikationsgerät 2, das in Fig. 2 dargestellt ist, innerhalb des Kommunikationsgerätes 2 angeordnet ist. Die von dem Host 1 adressierten Speichereinheiten bzw. Speicherbereiche/Speichersektoren des Flash-Speichers 9 werden ohne Umsetzung von logischen in physische Einheiten unmittelbar auf dem Flash-Speicher 9 angesprochen.

Da eine Umsetzung der Adressierung von logischen Einheiten des Hostes 1 in physische Einheiten des Flash-Speichers 9 mittels eines separaten Speichercontrollers eingespart wird, werden Sektoren des Dateisystems des Hostes 1, also Sektoren des Hostes 1, die in den Flash-Speicher 9 geschrieben werden sollen, an der Stelle in den Flash-Speicher 9 geschrieben, an der der Host 1 das Schreiben dieses Sektors vorgesehen hat.

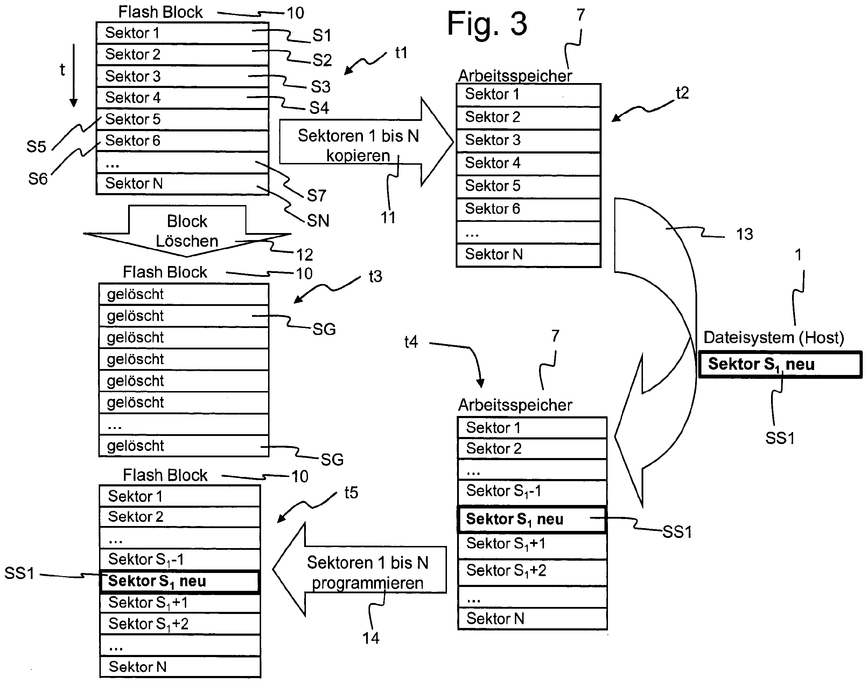

Ein einfaches Verfahren zum Speichern von Daten des Hostes 1 in dem Flash-Speicher 9 ist zu unterschiedlichen Zeitpunkten in Richtung des Pfeiles mit der Bezeichnung "t" in Fig. 3 dargestellt. In einem Block 10 des Flash-Speichers 9 sind Speichereinheiten in Form von Speichersektoren S1 bis SN vorgesehen, in die jeweils ein Sektor 1 bis N zu einem Zeitpunkt t1 abgespeichert ist. Zum Beschreiben des Blocks 10 mit einem neuen Sektor SS1 des Hostes 1 werden die in den Speichereinheiten S1 bis SN gespeicherten Sektoren 1 bis N vom Block 10 in den Arbeitsspeicher 7 kopiert, 11. Zu einem Zeitpunkt t2 sind daher die zum Zeitpunkt t1 im Block 10 gespeicherten Sektoren 1 bis N in dem Arbeitsspeicher 7 gespeichert. Der Block 10, in dem sich der zu speichernde neue Sektor SS1 befindet, muss vor dem Schreiben dieses Sektors SS1 gelöscht werden. Hierbei dürfen die Daten der vom Schreiben nicht betroffenen Speichereinheiten in dem zu beschreibenden Block 10 nicht verändert werden und müssen erhalten bleiben. Daher werden die Daten in Form der Sektoren 1 bis 10 aus dem kompletten Block 10 in den Arbeitsspeicher 7 geladen, 11. Danach wird der Arbeitsspeicher 7 zum Zeitpunkt t4 durch Beschreiben mit dem neuen Sektor SS1 abgeändert, 13. Nach Kopieren der Sektoren 1 bis N in den Arbeitsspeicher 7 wird zum Zeitpunkt t3 der Block 10 gelöscht, 12. Nach dem Löschen des Blocks 10 in Schritt 12 befinden sich in dem Block nur gelöschte Speichereinheiten mit gelöschten Speicherzellen SG. Zum Zeitpunkt t5 wird der komplett gelöschte Block 10 mit den im Arbeitsspeicher 7 abgespeicherten Daten inklusive des neuen Sektors SS1 programmiert, 14. Zum Zeitpunkt t5 ist der Block 10 somit mit dem Inhalt der Daten der Sektoren 1 bis N programmiert, wobei einer der Sektoren durch den neuen Sektor SS1 ersetzt ist. Um einen Sektor in den Flash-Speicher 9 zu schreiben, muss daher ein Block 10 komplett gelöscht und N Sektoren in den Flash-Speicher 9 programmiert werden, wobei N nicht nur den letzten Sektor im Block 10, sondern zusätzlich die Anzahl der in die Speichereinheiten S1 bis SN zu programmierenden Sektoren pro Block 10 darstellt. Die Operationen "Kopieren der Sektoren 1 bis N in den Arbeitsspeicher 7, 11" und "Programmieren des neuen Sektors SS1 im Arbeitsspeicher 7, 13" nehmen lediglich einen Bruchteil der Zeit in Anspruch gegenüber den Operationen "Block 10 löschen, 12" und "Programmieren der Sektoren 1 bis N in den Block 10, 14". Bei einer Bilanz des Aufwandes zum Speichern von Daten von dem Host 1 in den Flash-Speicher 9 können daher die Operationen 11 und 13 vernachlässigt werden.

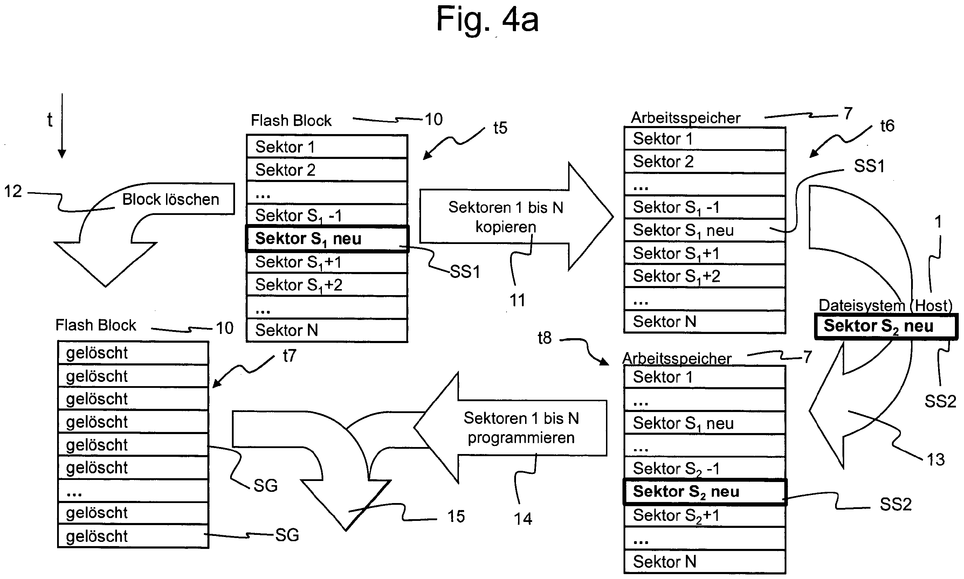

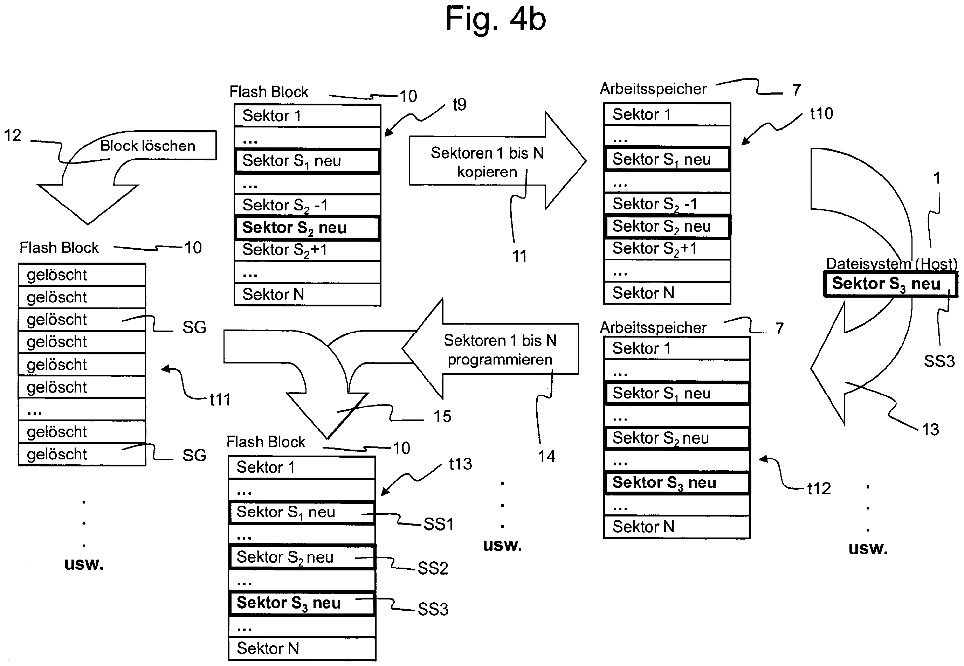

Während in Fig. 3 lediglich ein Sektor SS1 in den Flash-Speicher 9 geschrieben wird, ist in den Figuren 4a und 4b der Fall dargestellt, bei dem mehrere Sektoren SS2, SS3 von dem Host 1 in den Block 10 des Flash-Speichers 9 geschrieben werden. In Fig. 4a ist angenommen, dass der Block 10 sich in dem Zustand zum Zeitpunkt t5 gemäß Fig. 3 befindet. Zum Schreiben des Sektors SS2 in den Block 10 werden die Sektoren 1 bis N erneut von dem Block 10 in den Arbeitsspeicher 7 kopiert, 11, weshalb der Speicherzustand in dem Arbeitsspeicher 7 zum Zeitpunkt t6 dem zum Zeitpunkt t4 gemäß Fig. 3 entspricht. Nachfolgend wird der Block 10 zum Zeitpunkt t7 abermals gelöscht, wodurch sämtliche Speichereinheiten als gelöschte Speichereinheiten SG im Block 10 vorliegen. Der neue Sektor SS2 wird neben dem neuen Sektor SS1 in den Arbeitsspeicher 7 programmiert, 13, wobei zum Zeitpunkt t8 in dem Arbeitsspeicher 7 die neuen Sektoren SS1 und SS2 gespeichert sind, die zuvor gespeicherte Sektoren der Sektoren 1 bis N ersetzen. Anschließend werden die Sektoren 1 bis N inklusive der neuen Sektoren SS1 und SS2 in den gelöschten Block 10 programmiert, 14, 15, so dass zum Zeitpunkt t9 der Block 10 neben den Sektoren 1 bis N die neuen Sektoren SS1 und SS2 umfasst, siehe Fig. 4b. Anschließend wird der gesamte Inhalt des Blocks 10 wiederum in den Arbeitsspeicher 7 kopiert, 11, und anschließend wird der Block 10 zum Zeitpunkt t11 komplett gelöscht. Der Speicherinhalt des Arbeitsspeichers 7 zum Zeitpunkt t10 inklusive der neuen Sektoren SS1 und SS2 wird durch Speichern des neuen Sektors SS3 zum Zeitpunkt t12 erweitert. Neben den Sektoren 1 bis N sind zum Zeitpunkt t12 drei dieser Sektoren durch die neuen Sektoren SS1 bis SS3 ersetzt. Der Speicherinhalt des Arbeitsspeichers 7 wird durch Programmierung der aktualisierten Sektoren 1 bis N in den gelöschten Block 10 programmiert, 14, 15, wodurch in dem Block 10 die Sektoren 1 bis 10 programmiert sind, inklusive der neuen Sektoren SS1 bis SS3 in Ersatz dreier Sektoren der Sektoren 1 bis N. Wenn der Host 1 mehrere Sektoren 1 bis N in den Flash-Speicher 9 schreiben möchte, müssen die in Fig. 3 dargestellten Schritte für jeden zu schreibenden Sektor SS1, SS2, SS3 bis SSN wiederholt werden. Diese Wiederholung der Schritte bzw. Operationen 11, 12, 13 und 14 ist erforderlich, da der Flash-Speicher 9 wie der Hauptprozessor 6 keine Kenntnis über die logische Verwendung einzelner Sektoren hat und somit alle Sektoren 1 bis N in den Speichereinheiten S1 bis SN gleich behandeln muss.

Wenn der Host 1 eine bestimmte Anzahl von Sektoren M in den Flash-Speicher 9 schreiben möchte, sind M-mal ein Block 10 im Flash-Speicher 9 zu löschen und M-mal N Sektoren in den Flash-Speicher 9 zu programmieren. Wenn die Größe jeder der Speichereinheiten S1 bis SN mit der Größe der Sektoren 1 bis N jeweils übereinstimmt, ergeben sich bei einer Sektorgröße von 512 Byte und einer Blockgröße von 16 kB folgende Zahlen für die zum Speichern erforderlichen Operationen:
- Datei mit 4 kB entspricht 8 Sektoren entspricht 8-mal Block löschen, 12, und 8x32=256 Sektoren programmieren, 14
- Datei mit 10 kB entspricht 20 Sektoren entspricht 20-mal Block löschen, 12 und 20x32=640 Sektoren programmieren, 14
- Datei mit 16 kB entspricht 32 Sektoren entspricht 32-mal Block löschen, 12 und 32x32=1024 Sektoren programmieren, 14.

Wenn der Host 1 beispielsweise die Dateizuordnungstabelle (FAT) des Dateisystems des Hostes 1 in den Flash-Speicher 9 schreibt, und diese Tabelle beispielsweise 30 Sektoren umfasst, müssen 30-mal ein Block gelöscht und 30x32=960 Sektoren programmiert werden. Entsprechend müssen, wenn der Host 1 die Dateizuordnungstabelle FAT des Dateisystems erweitert und neu schreibt, mit 30 Sektoren wie im vorherigen Beispiel, wieder 30-mal einen Block 10 gelöscht und 30x32=960 Sektoren programmiert werden. Das in den Figuren 3, 4a und 4b geschilderte Verfahren, bei dem Daten aus einem kompletten Block in den Arbeitsspeicher geladen, die zu schreibenden Speichereinheiten geändert, der komplette Block gelöscht und mit den im Arbeitsspeicher zwischengespeicherten Daten neu beschrieben wird, ist beispielsweise bei der Implementierung eines Massenspeichers gegeben, die zu dem Microcontroller (PIC, PIC24, PIC32, etc.) der Firma Microchip mitgeliefert wird.

Um den hohen Aufwand an Löschungen von Blöcken und Programmierungen von Sektoren, der mit dem in den Figuren 3, 4 und 4a geschilderten Verfahren anfällt, zu reduzieren, kann man Zwischenspeicher (Cache) verwenden, in denen die zu schreibenden Daten zunächst gespeichert werden, um danach zeitlich verzögert in den Flash-Speicher geschrieben zu werden. Wenn in der Zwischenzeit zwischen Speicherung und Beschreiben des Flash-Speichers weitere zu schreibende Daten für denselben Block bei dem Zwischenspeicher eintreffen, können diese Daten mit den zwischengespeicherten Daten kombiniert werden und es muss der betreffende Block nur 1-mal gelöscht und beschrieben werden.

Eine weitere Alternative zur Vermeidung einer Vielzahl von Blocklöschungen und Sektor-Programmierungen wie in den Figuren 4a und 4b dargestellt, besteht in der Verwendung komplizierter Dateisysteme, beispielsweise dem TFFS (True Flash File System). Bei dem TFFS werden Daten im Flash-Speicher so verteilt, dass ein Löschen und Neuschreiben nicht sofort erforderlich ist, sondern erst dann, wenn der betreffende Block keine Daten enthält, also unbenutzt ist. In diesem Fall ist es jedoch erforderlich, das ursprüngliche Dateisystem, z. B. FAT, FAT32 in das auf dem Flash-Speicher verwendete Dateisystem zu "übersetzen". Sollen nämlich geänderte Daten in den Flash-Speicher geschrieben werden, werden diese Daten durch das Flash File System in einen freien, bereits gelöschten Block geschrieben und die alten Daten an der alten Stelle als "veraltet" markiert. Die logische Zuordnung der Daten zu dem tatsächlichen physischen Speicherort im Flash-Speicher erfolgt hierbei mittels Übersetzungstabellen. Erst wenn alle Daten in einem Block als "veraltet" markiert sind, kann dieser Block gelöscht werden. Die Löschung erfolgt dann, wenn der Speichercontroller, der die Übersetzungstabelle enthält und ausführt, nicht mit Lese-, Lösch- und Schreiboperationen befasst ist.

Während also bei einem Zwischenspeicher die zu schreibenden Daten im Arbeitsspeicher zwischengespeichert werden, wird das direkte Schreiben der Daten in den Flash-Speicher verzögert, um noch weitere Daten sammeln zu können, bevor sämtliche gesammelten Daten gemeinsam in den Flash-Speicher programmiert werden. Das Flash File System TFFS schreibt die Daten zwar sofort in den Flash-Speicher, verzögert jedoch das Löschen. Neben dem hohen technischen Aufwand zur Realisierung eines Zwischenspeichers oder eines separaten Speichercontrollers, der eine Übersetzungstabelle zur Kopplung der an der Schnittstelle zum Host adressierten logischen Einheiten mit den im Flash-Speicher verwendeten physischen Einheiten benötigt, kann bei einer gegenüber diesen Lösungen vereinfachten Lösung auf einen Zwischenspeicher oder separaten Speichercontroller zwar verzichtet werden, allerdings um den Preis eines erheblichen Aufwandes an Blocklöschungen und Sektor-Programmierungen.

Aufgabe der Erfindung ist es daher, ein Verfahren zur Steuerung eines Flash-Speichers zur Verfügung zu stellen, mit dem Daten eines Hostes einfach und effizient in dem Flash-Speicher abgespeichert werden können. Insbesondere soll die Anzahl der zur Speicherung erforderlichen Lösch- und Schreiboperationen ohne das Erfordernis einer Verwendung eines Zwischenspeichers und/oder eines separaten Speichercontrollers mit einer Übersetzungstabelle verringert werden. Mit der Angabe eines Verfahrens zur Steuerung eines Flash-Speichers, bei dem in vereinfachter Weise die Anzahl der zur Speicherung erforderlichen Lösch- und Schreiboperationen verringert ist, und der Angabe eines Computerprogrammproduktes zum Ausführen eines solchen Verfahrens werden Reaktionszeiten beim Speichern von Daten auf dem Flash-Speicher verkürzt und die Lebensdauer des Flash-Speichers wird verlängert.

Gemäß dem erfindungsgemäßen Verfahren zur Steuerung eines Flash-Speichers, der von einem Kommunikationsgerät, das an einen Host anschließbar ist, umfasst ist und zur Massenspeicherung mit zu speichernden Daten beschrieben wird, ist der Flash-Speicher in Blöcke, die jeweils Speichereinheiten umfassen, unterteilt. Eine beschriebene Speichereinheit ist nur erneut beschreibbar, wenn vor dem Beschreiben der Speichereinheit sämtliche Speichereinheiten des Blocks der zu beschreibenden Speichereinheit gelöscht werden. Der Flash-Speicher wird derart gesteuert, dass zumindest ein Teil von zu beschreibenden Speichereinheiten, deren Daten nach dem Beschreiben im Vergleich zu vor dem Beschreiben unverändert sind, weder gelöscht noch beschrieben wird, und zumindest ein Teil von zu beschreibenden gelöschten Speichereinheiten, deren Daten nach dem Beschreiben im Vergleich zu vor dem Beschreiben verändert sind, ohne erneute Löschung mit den zu speichernden Daten beschrieben wird. Eine derartige Steuerung des Flash-Speichers ist möglich bei einer Verwendung des Flash-Speichers als Nebenaggregat des Kommunikationsgerätes, wobei ein separater Speichercontroller nicht erforderlich ist. Zur Durchführung des erfindungsgemäßen Verfahrens ist ein Zwischenspeicher und/oder Speichercontroller mit einer Übersetzungstabelle ebenfalls nicht erforderlich. Die Steuerung des Flash-Speichers benötigt zudem keine Information über den logischen Inhalt der zu schreibenden Daten des Hostes oberhalb der Bitebene, in der die einzelnen Daten-Bits einen Inhalt mit dem Wert "0" oder "1" aufweisen können. Ein Byte besteht aus acht Bit. Jedes Bit kann den Wert "0" oder "1" annehmen. Die acht Bit eines gelöschten Bytes weisen alle den Wert "1" auf, so dass das Byte den binären Wert "11111111" aufweist. Dieser Wert entspricht in binärer Schreibweise dem Wert "0b11111111" oder in hexadezimaler Schreibweise dem Wert "0xFF". Es ist also möglich, dass der Steuerung des Flash-Speichers lediglich eine Information vorliegt, ob zu schreibende Daten Bytes mit jeweils einem Wert ungleich "0xFF" aufweisen. Diese Information kann durch Analyse der Werte auf der Ebene einzelner Bits, also auf der Bitebene, erfolgen. Alternativ oder zusätzlich kann diese Information auf der Ebene einzelner Bytes, also auf der Byteebene, erfolgen. Sofern ein Byte den hexadezimalen Wert "0xFF" aufweist, weisen sämtliche Bits des Bytes jeweils den Wert "0" auf. Mithin ist für einen Vergleich der Werte der Daten des Flash-Speichers mit denen der zuschreibenden Daten ausreichend, dass der Inhalt der Daten auf der Byteebene oder darunter, also auf der Bitebene, untersucht wird. Da gelöschte und nach der Löschung nicht wieder beschriebene Bereiche des Flash-Speichers stets den Wert "0xFF" aufweisen, ist die Information der Werte auf der Byteebene zur Bestimmung ausreichend, ob die gelöschten Bereiche oder ein Teil hiervon mit anderen Werten der einzelnen Bytes der zu schreibenden Daten zu überschreiben ist. Die Flash-Speicher-Steuerung muss daher lediglich eine Unterscheidung dahingehend treffen, ob sich der Wert jedes Bytes der zu schreibenden Daten von dem Wert jedes Bytes der zu beschreibenden gelöschten Speichereinheiten unterscheidet. Wenn die zu schreibenden Daten sich von den Werten der einzelnen Bytes der Daten der gelöschten Speichereinheiten unterscheiden, kann auf eine erneute Löschung der Speichereinheiten verzichtet werden und die Daten werden in die zu beschreibenden Speichereinheiten geschrieben. Falls sich die zu schreibenden Daten jedoch nicht von den Daten der zu beschreibenden Speichereinheiten unterscheiden, kann eine Speicherung in der zu beschreibenden Speichereinheite unterbleiben, weil die Werte der einzelnen Bytes der zu beschreibenden Speichereinheite den Werten der einzelnen Bytes der in die Speichereinheite einzuschreibenden Daten entsprechen. Auf diese Weise wird durch einen einfachen Vergleich der Entsprechung des Inhaltes der zu schreibenden Daten mit dem Inhalt der zu beschreibenden Speichereinheiten auf der Byteebene eine unnötige Löschung vermieden und die zu beschreibende Speichereinheite nur dann beschrieben, wenn aufgrund eines Unterschiedes des Inhaltes der zu beschreibenden Daten von dem Inhalt der zu beschreibenden Speichereinheite ein Schreiben erforderlich ist. Der Vergleich des Inhaltes der zu beschreibenden Daten mit dem Inhalt der zu beschreibenden Speichereinheiten kann ohne weitere Zwischenschritte unmittelbar vor der Speicherung der Daten in zumindest einen Teil der zu beschreibenden Speichereinheiten erfolgen.

Ein Flash-Speicher ist beispielsweise ein Flash-EEPROM-Halbleiterspeicher. Flash-Speichertypen, wie ein NOR-Flash, NAND-SLC oder NAND-MLC bieten sich als Flash-Speicher an. Das Kommunikationsgerät kann ein Computer, ein Mobiltelefon, ein Tablet-PC, PDA (Personal Digital Assistant), ein Smartphone oder ein anderes Kommunikationsgerät sein, das den Flash-Speicher umfasst. Der Flash-Speicher kann als Nebenaggregat, wobei ein Zwischenspeicher oder Speichercontroller vermieden wird, z.B. gemäß dem in den Figuren 1 und 2 dargestellten Kommunikationsgerät, oder als Hauptaggregat eines Kommunikationsgerätes verwenden werden, wobei ein vorhandener Zwischenspeicher und/oder Speichercontroller als eigene Baugruppe vorhanden ist.

Bei dem Kommunikationsgerät muss es sich nicht um ein Endgerät handeln, sondern das Kommunikationsendgerät kann selbst als Server ausgeführt sein, beispielsweise in Form eines Desktop-PCs oder Laptops. Da bei Daten, die nach dem Beschreiben im Vergleich zu vor dem Beschreiben unverändert sind, weder eine Löschung noch ein Beschreiben der zu beschreibenden Speichereinheiten erfolgt, und bei zu beschreibenden gelöschten Speichereinheiten oder einem Teil hiervon eine erneute Löschung unterbleibt und lediglich Daten eingeschrieben werden, die sich von den Daten gelöschter Speichereinheiten oder einem Teil hiervon unterscheiden, werden unnötige Lösch- und/oder Schreiboperationen vermieden. Auf diese Weise wird die Anzahl der zum Speichern von Daten in Flash-Speicher erforderlichen Lösch- und Schreib-/ Programmieroperationen reduziert, was sich in einer reduzierten Reaktionszeit beim Speichern und einer erhöhten Lebensdauer des Flash-Speichers äußert. Da zudem eine Verzögerung der Lösch- und/oder Schreiboperationen auf einen Vergleich des Inhaltes der zu schreibenden Daten mit dem Inhalt der zu beschreibenden Speichereinheiten auf der Ebene einzelner Bytes begrenzt ist und ein Zwischenspeicher und/oder ein sich von dem Hauptprozessor des Kommunikationsgerätes unterscheidender Speichercontroller entfallen kann, ist die Reaktionszeit beim Speichern von Daten reduziert und auf diese Weise die Gesamtperformance des Flash-Speichers maximiert.

Gemäß der vorliegenden Erfindung ist das Kommunikationsgerät über eine Schnittstelle an den Host angeschlossen und von dem Kommunikationsgerät werden Informationen über die Menge der von dem Host an den Flash-Speicher zu übertragenden Daten aus der Schnittstelle abgerufen und zur Steuerung des Flash-Speichers ausgewertet. Auch ohne einen Zwischenspeicher oder einen Speichercontroller liegen in der Schnittstelle zu dem Host Informationen über die Menge der von dem Host an den Flash-Speicher zu übertragenden Daten vor. Diese Daten werden aus der Schnittstelle abgerufen und zur Steuerung des Flash-Speichers ausgewertet, wobei Speichereinheiten, die bei einem Schreibvorgang nicht mit neuen Daten beschrieben werden, nach dem Löschen des Blocks im Flash-Speicher nicht mit den in der Speichereinheit gespeicherten Daten erneut beschrieben werden, sondern im gelöschten Zustand belassen werden, bis die neuen Daten bei einem späteren Schreibvorgang in die Speichereinheiten geschrieben werden sollen. Mit der in der Schnittstelle hinterlegten Information über die Menge der zu speichernden Daten ist es daher möglich, bei einem Schreibvorgang Speichereinheiten, die gelöscht sind, für das Eintreffen neuer Daten vorzuhalten, so dass diese nicht mit in der Speichereinheit bereits gespeicherten Daten überschrieben wird.

Mit Vorteil liegen die Informationen über die von dem Host an den Flash-Speicher zu übertragenden Daten in einem Massenspeicherprotokoll, insbesondere in einem USB-Massenspeicherprotokoll, vor. Das Massenspeicherprotokoll hat eine Information beispielsweise darüber, wie viele Sektoren des Hostes in den Flash-Speicher geschrieben werden sollen. Diese Information wird an eine Schreibfunktion des Flash-Speichers wietergegeben. Die Schreibfunktion verhindert nun, dass gerade gelöschte Speichereinheiten mit Daten beschrieben werden, die in einem nachfolgenden Schreibvorgang überschrieben werden. Diese Speichereinheiten verbleiben daher im gelöschten Zustand, so dass lediglich neue Daten in den Flash-Speicher programmiert werden, ohne die zu programmierenden Speichereinheiten vor dem Beschreiben mit neuen Daten nochmals löschen zu müssen. Die Information über die von dem Host an den Flash-Speicher zu übertragenden Daten liegt insbesondere bei einem USB-Massenspeicherprotokoll vor. Die Information liegt hierbei unabhängig von einem Zwischenspeicher oder einem Speichercontroller in der Schnittstelle zu dem Host vor.

Gemäß der vorliegenden Erfindung wird eine Information über die Anzahl von aufeinanderfolgenden zu beschreibenden Speichereinheiten, in die die zu übertragenden Daten geschrieben werden sollen, von der Schnittstelle bereitgestellt. Mit der Information über die Anzahl aufeinanderfolgender zu beschreibender Speichereinheiten können zusammenhängende Bereiche eines Blocks eines Flash-Speichers für das Beschreiben mit neuen Daten für aufeinanderfolgende Schreiboperationen vorgehalten bzw. reserviert werden. Da die Größe des Dateninhaltes eines Sektors des Hostes in der Schnittstelle zur Übertragung der Daten bekannt sein muss, kann allein aus der Menge von Sektoren, die in den Flash-Speicher eingeschrieben werden sollen, auf die Anzahl aufeinanderfolgender zu beschreibender Speichereinheiten geschlossen werden.

In einer weiteren Ausführungsform wird neben dem Inhalt der ersten zu beschreibenden Speichereinheiten eine Zusatzinformation über eine Anzahl der der ersten Speichereinheit nachfolgenden Speichereinheiten von der Schnittstelle bereitgestellt. Wenn also der Host eine bestimmte Anzahl von Sektoren, deren Größe jeweils der einer bestimmten Anzahl von Speicherzellen einer Speichereinheit entspricht, in den Flash-Speicher schreiben möchte, gibt der Host über die Schnittstelle den Auftrag an den Flash-Speicher einen ersten Sektor in den Flash-Speicher zu schreiben mit der Zusatzinformation, dass bei M zu schreibenden Sektoren noch M-1 Sektoren folgen werden. Der Block des Flash-Speichers, in den der erste Sektor in einen Teil der Speicherzellen der Speichereinheiten des Blockes geschrieben werden soll, muss vor dem Schreiben des Sektors gelöscht werden, da nur komplette Blöcke löschbar sind. Die Daten der vom Schreiben bei einem Schreibvorgang nicht betroffenen Speichereinheiten in diesem Block dürfen während des Schreibvorgangs nicht verändert werden und müssen erhalten bleiben. Dazu werden die Daten aus dem kompletten Block zwischengespeichert, beispielsweise in einem Arbeitsspeicher des Kommunikationsgerätes, die zu schreibenden Daten den zwischengespeicherten Daten hinzugefügt durch Ersatz gegen einen Teil der zwischengespeicherten Daten, der komplette Block im Flash-Speicher gelöscht und mit den zwischengespeicherten Daten, die die zu schreibenden Daten umfassen, neu programmiert. Dabei werden nur diejenigen Daten in den Flash-Speicher programmiert, die unverändert bleiben müssen, also diejenigen Sektoren vor dem ersten Sektor S, sowie diejenigen Sektoren ab dem Sektor S+M, wobei der erste Sektor S selbst, der bereits neue Daten enthält, ebenfalls programmiert wird. Wenn die nachfolgenden Sektoren S+1 bis S+M-1 vom Host übertragen werden, werden diese Sektoren jeweils in die bereits gelöschten vorgehaltenen Bereiche im Flash-Speicher programmiert. Auf diese Weise werden diejenigen zu beschreibenden Bereiche im Flash-Speicher, deren Daten nach dem Beschreiben im Vergleich zu vor dem Beschreiben unverändert sind, weder gelöscht noch beschrieben, sondern vorgehalten für diejenigen Schreibvorgänge, mit denen diese Bereiche mit neuen Daten beschrieben werden sollen. Ohne Information über den Inhalt der in dem Flash-Speicher zu beschreibenden Daten ist es daher nur mit der Information über die Menge der zu schreibenden Daten möglich, Lösch- und Schreibvorgänge ohne Verlust an gespeicherten Daten einzusparen.

In einer vorteilhaften Ausführungsform werden vom Host übertragene in zumindest einer Speichereinheit eines Blocks des Flash-Speichers zu schreibende Daten vor dem Beschreiben der zumindest einen Speichereinheit invertiert. Auf diese Weise kann bei Dateisystemen, die für ungenutzte Speichereinheiten den hexadezimalen Wert "0x00" verwenden, durch Inversion der Wert "0xFF" erzeugt werden, der dem Wert von gelöschten, nicht beschriebenen Speichereinheiten im Flash-Speicher entspricht. Die Inversion erfolgt indem jedes Bit, das den Wert "0" hat, in den Wert "1" transformiert wird und umgekehrt. Auf diese Weise werden ungenutzte Bereiche des Dateisystems, die den Wert "0x00" aufweisen, zu Bereichen mit dem Wert "0xFF". Da der Wert "0xFF" eines Bytes im Flash-Speicher dem gelöschten, nicht beschriebenen Zustand entspricht, müssen die ungenutzten Bereiche des Dateisystems nach dem Invertieren nicht mehr programmiert werden. Erst wenn sich der Inhalt des Dateisystems in diesem Bereich ändert und andere Werte als "0x00" enthält, muss auch nach dem Invertieren dieser Bereich in den Flash programmiert werden. Dann ist jedoch kein Löschen vor der Programmierung erforderlich, da der gelöschte Bereich immer noch die gelöschten Bytes mit dem Wert "0xFF" enthält und ohne vorheriges Löschen überschrieben werden kann. Der Wert "0" entspricht dem hexadezimalen Wert "0x00", wobei beispielsweise beide Kopien einer Dateizuordnungstabelle FAT an den ungenutzten Stellen den Wert "0" aufweisen. Unbenutzte Teile des Dateisystems werden häufig geschrieben, ohne sich zu ändern. Für den Flash-Speicher bedeutet das Schreiben bei jedem Schreibvorgang ein Löschen und Neuprogrammieren der Speichereinheiten. Durch ein Invertieren der ungenutzten Bereiche des Dateisystems wird der Wert dieser Bereiche invertiert in den Wert gelöschter, nicht beschriebener Bereiche des Flash-Speichers. Durch diese Angleichung der Werte von ungenutzten Bereichen des Dateisystems an die Werte gelöschter Speichereinheiten ist eine Programmierung dieser Bereiche nicht mehr erforderlich. Daher tritt mit diesem Ausführungsbeispiel eine weitere Reduzierung von Lösch- und/oder Schreiboperationen ein.

In einer weiteren Ausführungsform werden bei mehreren zu beschreibenden Speichereinheiten, in die die zu übertragenden Daten geschrieben werden sollen, die Daten für sämtliche Speichereinheiten invertiert. Diese Ausführungsform hat zwar den Nachteil, dass man für benutzte Bereiche des Dateisystems die nicht den Wert "0x00" aufweisen, invertieren muss, um diese Daten beim Auslesen aus dem Flash-Speicher verwenden zu können. Das Ausführungsbeispiel hat aber den Vorteil, dass der Flash-Speicher keine Information über den logischen Inhalt der zu speichernden Daten benötigt. Die Operation "Invertieren von Daten" wird ähnlich wie die Operationen "Kopieren der Sektoren 1 bis N", 11, siehe Figur 3, 4a und 4b und "Programmieren von neuen Sektoren in den Arbeitsspeicher, 13, siehe Figuren 3, 4a und 4b" vernachlässigt, da sie lediglich einen Bruchteil der Zeit benötigen, die für das Löschen des Blocks, 12, und das Programmieren des Blocks, 14 erforderlich ist.

Entsprechend ist in einer weiteren Ausführungsform vorgesehen, dass ungenutzte Bytes von Daten des Hostes, die in den Flash-Speicher geschrieben werden sollen, bei Ablage in der Schnittstelle den hexadezimalen Wert 0x00 aufweisen, nach dem Invertieren den hexadezimalen Wert 0xFF eines gelöschten Bytes im Flash-Speicher aufweisen, und anstelle eines Schreibens des hexadezimalen Wertes 0xFF in eine gelöschte Speichereinheit die gelöschte Speichereinheit ohne erneute Löschung im gelöschten Zustand gehalten wird.

Neben dem Verfahren zur Steuerung eines Flash-Speichers betrifft die vorliegende Erfindung weiter ein Computerprogrammprodukt zum Ausführen eines solchen Verfahrens. Beispielsweise kann das Computerprogrammprodukt als Software vorliegen. Das Computerprogrammprodukt kann als binäre Daten, auf Floppy Disk, einer DVD, einer CD-Rom oder auf einer Speicherkarte gespeichert vorliegen. Weiter kann das Computerprogrammprodukt als ausgedruckter Source Code vorliegen.

Weiter umfasst die Erfindung ein Kommunikationsgerät, auf dem das Computerprogrammprodukt installiert ist. Das Kommunikationsgerät weist dem erfindungsgemäßen Verfahren zur Steuerung eines Flash-Speichers entsprechende Wirkungen und Vorteile auf und kann als Desktop-PC, als Laptop, Server, Festnetztelefon, Mobiltelefon, Smartphone oder Tablet-PC vorliegen. Der Host, an das das Kommunikationsgerät anschließbar ist, kann als Server oder anderer Host vorliegen. Der Host kann daneben als Verbund und/oder Netzwerk von netzwerkfähigen Computern in Form eines Host-Systems vorliegen. So kann der Host auch als Internet oder Ethernet ausgeführt sein.

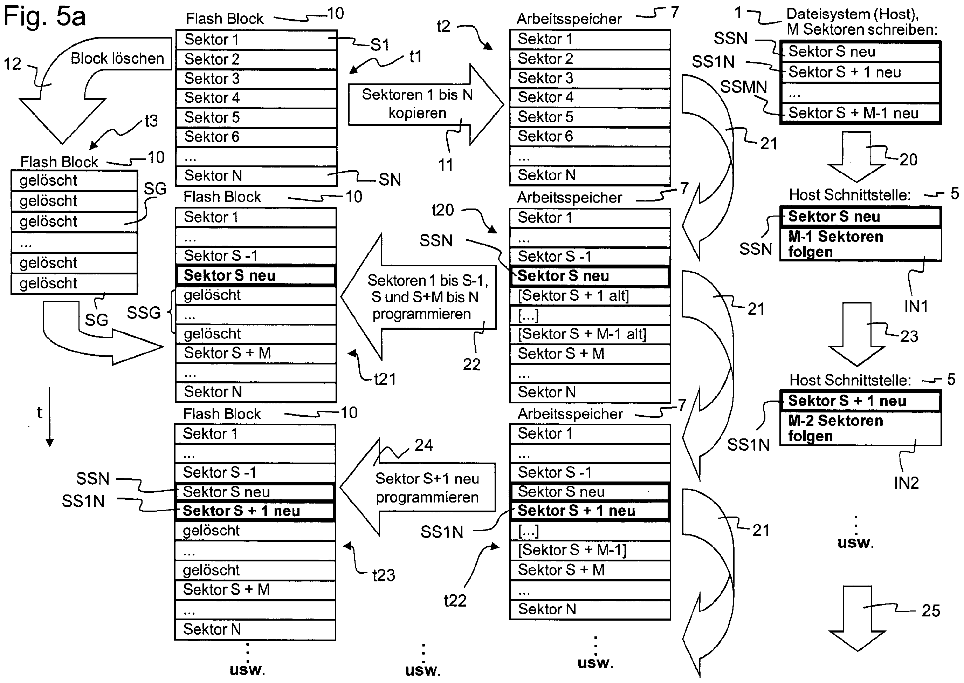

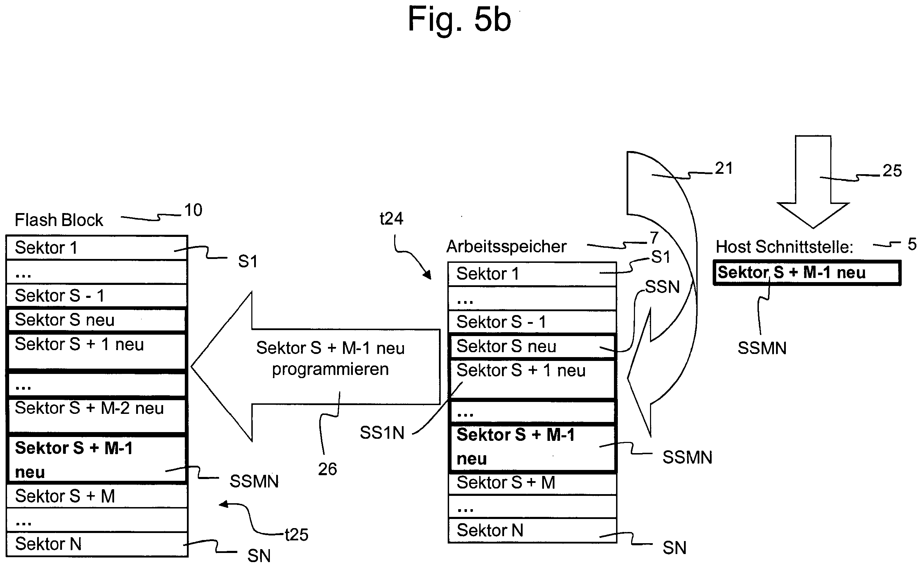

Weitere Ausführungsbeispiele sowie Vorteile der Erfindung werden nachfolgend anhand der Figuren 5 bis 8 erläutert. Zur besseren Anschaulichkeit wird in den Figuren auf eine maßstabs- oder proportionsgetreue Darstellung verzichtet. In den Figuren bezeichnen, sofern nicht anders angegeben, gleiche Bezugszeichen gleiche Teile mit gleicher Bedeutung, wobei auf die Bezugszeichen der bereits diskutierten Figuren 1 bis 4b Bezug genommen wird. Es zeigen:
Fig. 1 ein herkömmliches Kommunikationsgerät, das einen Flash-Speicher 9 umfasst,
Fig. 2 das in Fig. 1 dargestellte herkömmliche Kommunikationsgerät, wobei die Steuerung des Flash-Speichers über einen Hauptprozessor erfolgt, der über eine Schnittstelle an einen Host angeschlossen ist,
Fig. 3 ein herkömmliches Verfahren zum Speichern eines Sektors in einem Flash-Speicher,
Fig. 4a und 4b ein herkömmliches Verfahren zum Speichern mehrerer Sektoren in einem Flash-Speicher,
Fig. 5a und 5b eine erste Ausführungsform des erfindungsgemäßen Verfahrens zum Speichern mehrerer aufeinanderfolgender Sektoren in einem Flash-Speicher,
Fig. 6a und 6b eine weitere Ausführungsform des erfindungsgemäßen Verfahrens zum Abspeichern von spezifischen Sektoren eines Hostes in einen Flash-Speicher,
Fig. 7a und 7b ein weiteres Ausführungsbeispiel des erfindungsgemäßen Verfahrens zum wiederholten Schreiben von spezifischen Sektoren eines Hostes in einen Flash-Speicher mittels Invertieren, und
Fig. 8a und 8b jeweils eine Tabelle zum Vergleich der in den Figuren 4 bis 7 dargestellten Verfahren hinsichtlich der Anzahl der Löschoperationen (Fig. 8a) und hinsichtlich der Anzahl der Programmieroperationen (Fig. 8b).

In den Figuren 5a und 5b ist das erfindungsgemäße Verfahren in einer ersten Ausführungsform dargestellt, bei der mehrere aufeinanderfolgende Sektoren SSN, SS1N, SSMN in den Block 10 des Flash-Speichers 9 gespeichert werden sollen. Zum Zeitpunkt t1 sind Sektoren 1 bis N in den Speichereinheiten S1 bis SN des Blocks 10 gespeichert. Danach werden die Sektoren 1 bis N in den Arbeitsspeicher 7 kopiert, 11, so dass zum Zeitpunkt t2 in dem Arbeitsspeicher 7 die Sektoren 1 bis N gespeichert sind. Zum Zeitpunkt t3 wird der Block 10 komplett gelöscht, so dass jede der Speichereinheiten S1 bis SN im gelöschten Zustand SG ist. Die Verfahrensschritte zu den Zeitpunkten t1 bis t3 unterscheiden sich nicht von denen, die in der Fig. 3 dargestellt sind. M Sektoren sollen von dem Host 1 in den Flash-Speicher 9 programmiert werden. Diese M Sektoren teilen sich auf in den Sektor S neu, SSN, den Sektor S+1 neu, SS1N, weitere Sektoren und den Sektor S+M-1 neu, SSMN, wobei M eine ganze Zahl ist. Statt lediglich den ersten zu schreibenden Sektor SSN in den Arbeitsspeicher zu schreiben, wie dies in Fig. 3 zum Zeitpunkt t4 dargestellt ist, wird durch die Schnittstelle 5 der erste zu beschreibende Sektor SSN und eine Information IN1 an das Kommunikationsgerät 2, dass noch M-1 Sektoren, die in den Flash-Speicher 9 zu schreiben sind, folgen. Zum Zeitpunkt t20 wird lediglich der erste Sektor SSN in den Arbeitsspeicher 7 gespeichert, 21, wobei nicht der gesamte Inhalt des Arbeitsspeichers 7 zum Zeitpunkt t20 in den gelöschten Block 10 programmiert wird. Stattdessen werden die Sektoren 1 bis S-1, S als neuer Sektor SSN und die Sektoren S+M bis N programmiert, 22. Zum Zeitpunkt t21 sind daher die Speichereinheiten, die zwischen dem Sektor SSN und dem Sektor S+M angeordnet sind, gelöscht. Dieser gelöschte Bereich des Blocks 10, SSG, steht für nachfolgende Schreiboperationen bzw. Schreibvorgänge zum Beschreiben neuer Daten des Hostes in den Block 10 bereit. Das Kommunikationsgerät 2 oder die Steuerung des Flash-Speichers 9 wendet also die Information IN1, dass noch M-1 Sektoren zum Beschreiben in den Flash-Speicher 9 folgen, derart auf das Beschreiben des Blocks 10 an, dass die in den Block 10 des Flash-Speichers 9 noch nicht eingeschriebenen Sektoren SS1N bis SSMN als gelöschter Bereich SSG im Block 10 vorgehalten werden. Zum Zeitpunkt t22 ist der Arbeitsspeicher 7 mit dem nächsten zu beschreibenden Sektor S+1 neu, SS1N beschrieben, wobei von der Schnittstelle 5 neben dem nächsten zu beschreibenden Sektor SS1N die Information IN2 an das Kommunikationsgerät 2 weitergeleitet hat, dass noch M-2 Sektoren zum Beschreiben des Blocks 10 folgen. Die Information IN2 wird an die Steuerung des Flash-Speichers 9, die bei dem Kommunikationsgerät 2, das in Fig. 2 dargestellt ist, durch den Hauptprozessor 6 übernommen wird, übermittelt. Daraufhin wird lediglich der neue Sektor S+1 neu, SS1N, in den Block 10 programmiert, 24, wodurch der Block 10 zum Zeitpunkt t23 neben dem ersten neuen Sektor SSN den zweiten neuen Sektor SS1N gespeichert hat. Gemäß der zeitlichen Abfolge, die in den Figuren 3, 4a, 4b, 5a, 5b, 6a, 6b, 7a und 7b als nach unten gerichteter Pfeil mit dem Buchstaben t für Zeit, eingetragen ist, setzt sich das Verfahren der Speicherung einzelner neuer Sektoren aus der Schnittstelle 5 in den Arbeitsspeicher 7 und von dort in den Block 10 fort, wie dies durch den Ausdruck "usw." und den Pfeil 25 in Fig. 5a dargestellt ist. Sobald der letzte zu speichernde Sektor SSMN in den Block eingeschrieben werden kann, wird dieser Sektor in den Arbeitsspeicher 7 eingespeichert, 21, und der letzte neue in den Flash-Speicher 9 einzuspeichernde Sektor S+M-1 neu, SSMN wird in die letzte noch verbleibende Speichereinheit, die im gelöschten Zustand SG ist, des Bereiches gelöschter Einheiten SSG eingespeichert. Bei der letzten der M Sektoren, die aufeinanderfolgend zu speichern sind, wird keine weitere Information von der Schnittstelle an die Steuerung des Flash-Speichers 9 übermittelt, da eine solche Information nicht erforderlich ist. Denn der gelöschte vorbehaltene Bereich SSG ist aufgrund der ersten Mitteilung IN1, dass M-1 Sektoren in den Block 10 des Flash-Speichers 9 zu speichern sind, derart vorgehalten, dass dieser gelöschte Bereich für sämtliche der M Sektoren, die in den Block 10 einzuschreiben sind, ausreicht. Insofern ist in einer weiteren Ausführungsform lediglich die Übermittlung der Information IN1 erforderlich, dass M-1 Sektoren in den Speicher noch einzuschreiben sind, wobei die Information IN2, wonach M-2 Sektoren in den Flash-Speicher 9 einzuschreiben sind, entfallen kann.

Wenn der Host 1 eine bestimmte Anzahl von aufeinanderfolgenden Sektoren M in den Flash-Speicher 9 schreiben möchte, und diese einzuschreibenden Sektoren alle in Speichereinheiten eines Blocks 10 einzuschreiben sind, dann ist der Block 10 im Flash-Speicher 9 1-mal zu löschen und N Speichereinheiten sind in dem Flash-Speicher 9 zu programmieren. Sind die aufeinanderfolgenden Sektoren auf mehrere Blöcke verteilt, was der Fall ist, wenn die Summe der Zahlen S und M größer ist als die Anzahl N der Speichereinheiten im Block, dann muss man sämtliche Blöcke B, die zur Speicherung heranzuziehen sind, jeweils 1-mal löschen und BxN Sektoren sind in den Flash-Speicher 9 zu programmieren. Bei dieser Betrachtung ist angenommen, dass die Datenmenge einer Speichereinheiten der Datenmenge eines Sektors entspricht.

Bei einer Sektorgröße von 512 Byte und einer Blockgröße von 16 kB sind folgende Operationen beim Schreiben des Flash-Speichers 9 erforderlich:
- Datei mit 4 kB entspricht 8 Sektoren (in einem Block) entspricht 1-mal Block löschen und 32 Sektoren programmieren,
- Datei mit 4 kB entspricht 8 Sektoren (in zwei Blöcken) entspricht 2-mal Block löschen und 2x32=64 Sektoren programmieren,
- Datei mit 10 kB entspricht 20 Sektoren (in zwei Blöcken) entspricht 2-mal Block löschen und 2x32=64 Sektoren programmieren,
- Datei mit 16 kB entspricht 32 Sektoren (zwei Blöcke) entspricht 2-mal Block löschen und 2x32=64 Sektoren programmieren.

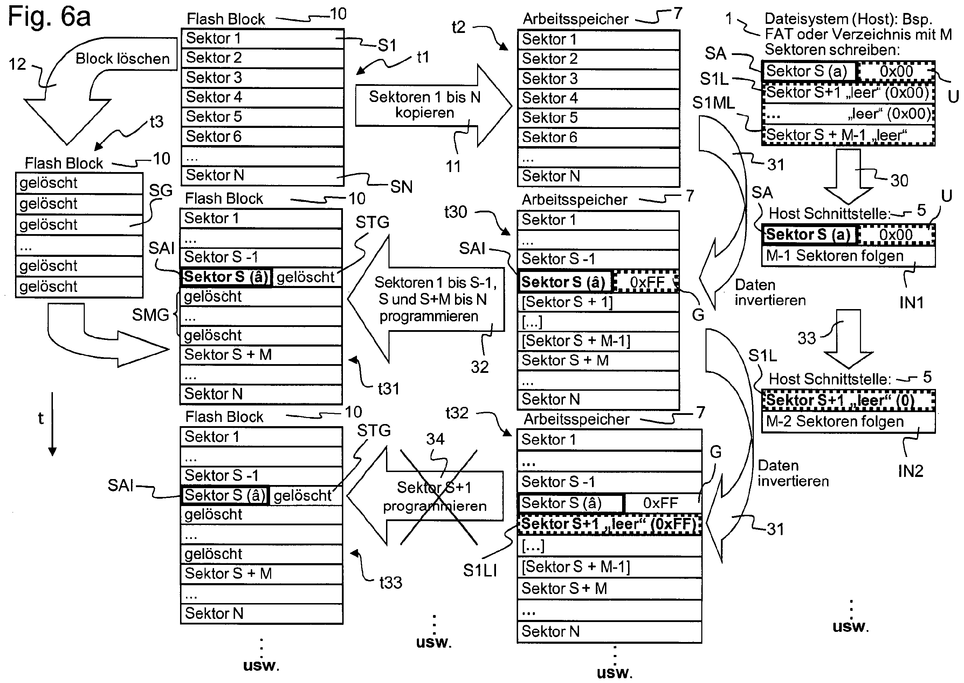

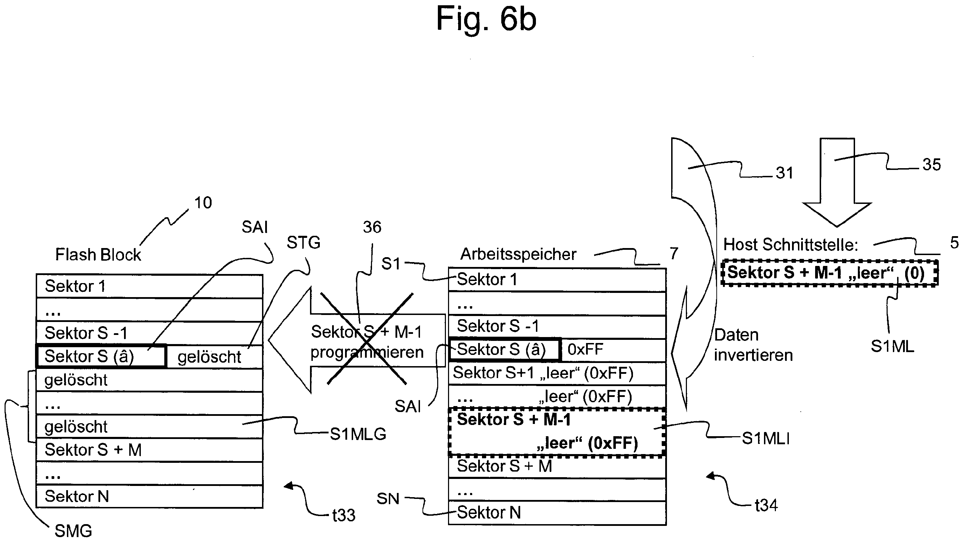

Wenn beispielsweise der Host 1 die Dateizuordnungstabelle FAT des Dateisystems schreibt und diese aus 30 Sektoren besteht, dann müssen maximal bei Verteilung der 30 Sektoren auf 2 Blöcke 2-mal ein Block gelöscht und 2x32=64 Sektoren programmiert werden. Wenn der Host die FAT des Dateisystems erweitert und neu schreibt mit wie im vorherigen Beispiel 30 Sektoren, dann sind wieder 2-mal ein Block zu löschen und 2x32=64 Sektoren in den Flash-Speicher 9 zu programmieren. In den Figuren 6a und 6b ist das erfindungsgemäße Verfahren in einer weiteren Ausführung dargestellt, bei der spezifische Sektoren des Hostes 1 in dem Flash-Speicher 9 geschrieben werden. Wie bei den Figuren 3 und 5a geschildert, wird der Block 10, der zum Zeitpunkt t1 die Sektoren 1 bis N in den Speichereinheiten S1 bis SN umfasst, in den Arbeitsspeicher 7 komplett kopiert, 11, und anschließend wird der Block 10 komplett gelöscht zum Zeitpunkt t3, wodurch sich sämtliche Speichereinheiten S1 bis SN im Block 10 im gelöschten Zustand SG befinden. Der Host 1 beabsichtigt eine FAT oder ein Verzeichnis mit M Sektoren in den Flash-Speicher 9 zu schreiben. Der Host erteilt daher über die Schnittstelle 5 einen Auftrag an die Steuerung des Flash-Speichers 9, den ersten der M Sektoren, der einen ersten Teilbereich SA und einen zweiten Teilbereich U umfasst, in den Block 10 zu schreiben mit der Zusatzinformation IN1, dass noch M-1 Sektoren zur Speicherung folgen. Die Information IN1 als Zusatz zu den Teilbereichen SA und U des ersten zu schreibenden Sektors erstellt die Schnittstelle 5 aus der Information des Hostes 1, wie viele Sektoren zu schreiben sind. Im Gegensatz zu der ersten Ausführungsform des erfindungsgemäßen Verfahrens gemäß den Figuren 5a und 5b werden die in den zu speichernden Teilbereichen SA und U des ersten zu speichernden Sektors enthaltenden Daten invertiert, 31. Hierbei wird der erste Teilbereich SA des ersten zu schreibenden Sektors in den ersten Teilbereich SAI invertiert, wobei der unbenutzte zweite Teilbereich des ersten zu speichernden Sektors U, der den hexadezimalen Wert 0x00 enthält, in den zweiten Teilbereich G des ersten zu schreibenden Sektors invertiert, der nach der Inversion den hexadezimalen Wert 0xFF enthält. Der auf diese Weise invertierte erste zu schreibende Sektor wird daher als invertierter erster Teilbereich SAI und als zweiter invertierter Teilbereich G in den Arbeitsspeicher 7 zum Zeitpunkt t30 programmiert. Danach werden entsprechend dem Programmierschritt 22 in Fig. 5a die Sektoren 1 bis S-1, der zu schreibende invertierte Sektor S mit den Teilbereichen SAI und G und die Sektoren S+M bis N in den Block 10 programmiert, 32. Es werden also nur diejenigen Daten in den Flash-Speicher 9 programmiert, die unverändert bleiben müssen, mithin sämtliche Sektoren, die dem Sektor S vorgehen, sowie die Sektoren, die ab dem Sektor S+M folgen, sowie der erste zu beschreibende Sektor selbst, der die neuen, invertierten Daten enthält. Zum Zeitpunkt t31 ist in dem Block 10, der die unveränderten Sektoren 1 bis S-1 und S+M bis N enthält, ein gelöschter Bereich SMG vorhanden, der für die weiteren zu speichernden Sektoren des Hostes zur Verfügung steht. Hinsichtlich des ersten zu speichernden Sektors werden lediglich Daten im Block 10 gespeichert, die sich von dem Wert 0xFF für gelöschte Daten in den Speichereinheiten des Blocks 10 unterscheiden. Daher wird lediglich der erste Teilbereich des ersten zu speichernden Sektors, SAI, in den Block 10 gespeichert und der zweite invertierte Teilbereich G des ersten zu speichernden Sektors wird nicht in den Block 10 programmiert, da dessen Wert dem Inhalt gelöschter Speichereinheiten 0xFF entspricht. Der dem ersten einzuschreibenden Sektor folgende zweite Sektor S1L ist ein sogenannter "leerer" Sektor, da die Daten in diesem Sektor unbenutzte Bytes mit dem Wert 0, der dem hexadezimalen Wert 0x00 entspricht, enthalten. Der Sektor S1L wird wie bei der Speicherung des ersten einzuschreibenden Sektors in den Arbeitsspeicher 7 invertiert, 31 und im Arbeitsspeicher 7 als invertierter Sektor S1LI abgespeichert. Daneben übermittelt die Schnittstelle die Information IN2, dass noch M-2 Sektoren in den Flash-Speicher 9 einzuspeichern sind, an die Steuerung des Flash-Speichers 9. Da der zweite einzuschreibende Sektor S1LI nach der Invertierung ausschließlich den hexadezimalen Wert 0xFF aufweist, der dem Inhalt der Speichereinheiten im gelöschten Zustand SG des gelöschten Bereiches SMG entspricht, wird dieser Sektor nicht in den Block 10 programmiert, 34. Stattdessen ist der Block zum Zeitpunkt t33 in dem gleichen Zustand wie zum Zeitpunkt t31. Da der Inhalt gelöschter Speichereinheiten dem Inhalt des zweiten einzuschreibenden Sektors S1LI entspricht, wird durch die nicht durchgeführte Programmierung des invertierten zweiten einzuschreibenden Sektors S 1 LI kein Datengehalt verloren.

Wenn nachfolgende Sektoren vom Host 1 an die Schnittstelle 5 übertragen werden, werden diese nur dann in den bereits gelöschten Bereich SMG im Flash-Speicher 9 programmiert, wenn sie Daten enthalten, die sich von unbenutzten Daten mit dem Wert 0, der dem hexadezimalen Wert 0x00 entspricht, unterscheiden. Solange diese Sektoren "leer" sind, also nur Bytes mit 0x00 enthalten, werden diese Bereiche durch das Invertieren zu Bereichen, bei denen sämtliche Bytes den Wert 0xFF enthalten, die dem Inhalt gelöschter Speichereinheiten des gelöschten Bereiches SMG im Flash-Speicher entsprechen. Diese "leeren" Sektoren werden daher nicht in den Flash-Speicher programmiert. Gemäß der Darstellung in Fig. 6b ist auch der letzte einzuspeichernde Sektor S1ML ein Sektor, der ausschließlich unbenutzte Bytes mit dem Wert 0 enthält. Nach dem Invertieren liegt dieser Sektor als invertierter Sektor S1 MLI mit den Werten 0xFF im Arbeitsspeicher 7 zum Zeitpunkt t34 vor. Da der invertierte letzte einzuschreibende Sektor S1 MLI den gleichen Datengehalt aufweist, wie der gelöschte Bereich SMG im Block 10 findet kein Programmierschritt zur Einschreibung des Sektors S1 MLI in den Block 10 statt, 36. Stattdessen entspricht der gelöschte Speicherbereich S1MLG des gelöschten Bereiches SMG dem Dateninhalt des letzten einzuschreibenden invertierten Sektors S1MLI. Durch das Invertieren von Daten von einzuschreibenden Sektoren, die unbenutzte Daten enthalten, wird erfindungsgemäß auf einen Programmierschritt verzichtet, weil sich die Daten gelöschter Speichereinheiten und die invertierten Daten von Sektoren mit unbenutzten Daten entsprechen. Zwar muss zur Verwendung der invertiert gespeicherten Daten eine Rückinversion vorgenommen werden, die einer weiteren Invertierung entspricht, allerdings fällt der Zeit- und Rechenaufwand für die Inversion im Verhältnis zum Zeit- und Rechenaufwand für die Programmierung kaum ins Gewicht und kann vernachlässigt werden.

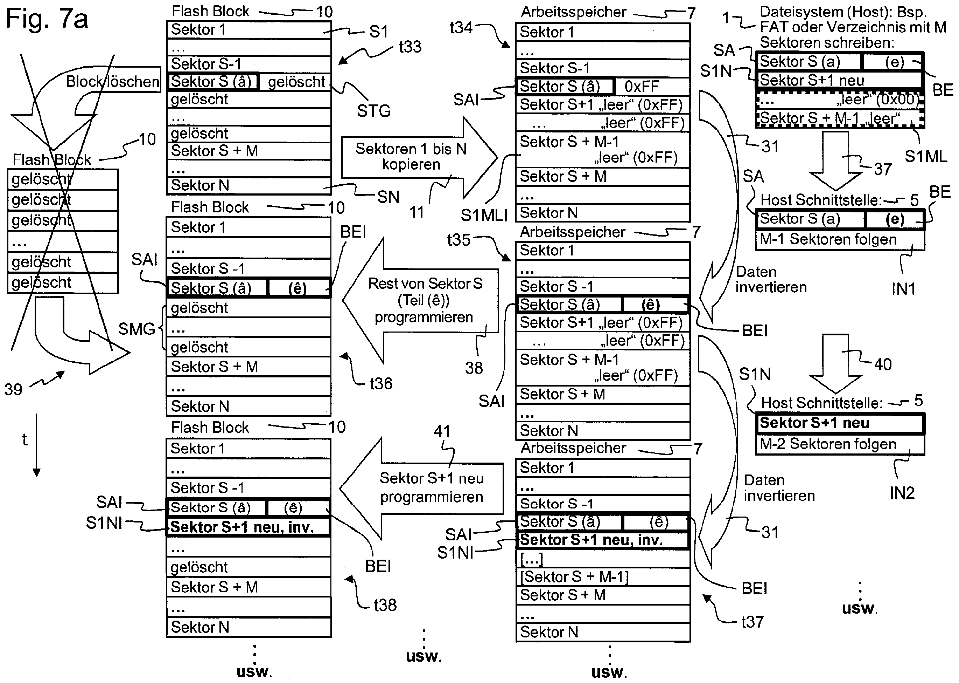

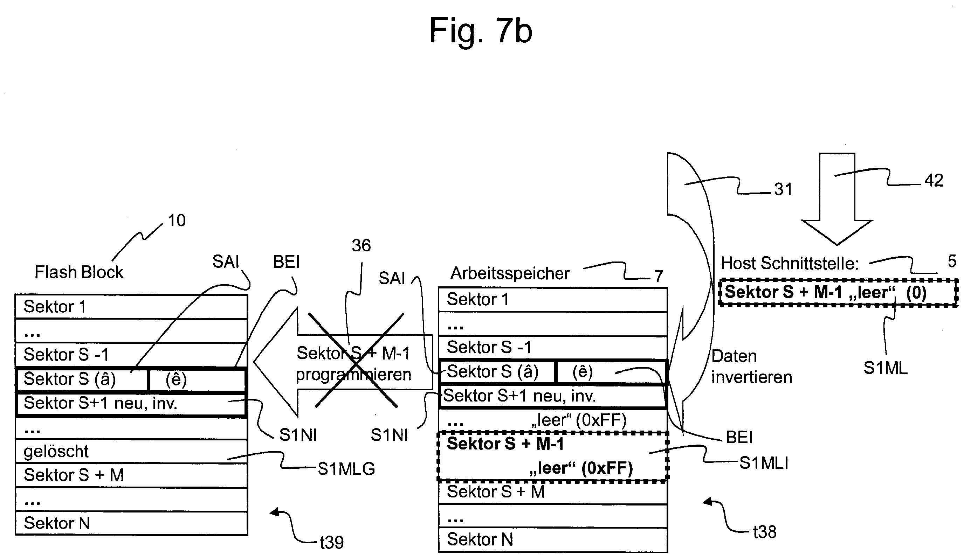

In den Figuren 7a und b ist eine weitere Ausführungsform des erfindungsgemäßen Verfahrens dargestellt, bei dem wiederholt spezifische Sektoren des Hostes 1 in den Flash-Speicher 9 geschrieben werden. In Fig. 7a wird als Ausgangszustand des Blocks 10 der Zustand zum Zeitpunkt t33 wie in Fig. 6a und 6b jeweils dargestellt, angenommen. Nach Kopieren sämtlicher Sektoren 1 bis N in den Arbeitsspeicher 7 zum Zeitpunkt t34, der dem Zeitpunkt t34 in Fig. 6b entspricht, sollen wiederum M Sektoren in den Flash-Speicher 9 geschrieben werden. Der erste einzuschreibende Sektor umfasst einen ersten Teilbereich SA und einen zweiten Teilbereich BE sowie einen zweiten einzuschreibenden Sektor S1N. Die weiteren einzuschreibenden Sektoren sind sogenannte "leere" Sektoren, die lediglich unbenutzte Daten enthalten. Der letzte einzuschreibende "leere" Sektor ist der Sektor S+M-1, S1ML. Nach Übermittlung der einzuschreibenden Sektoren an die Schnittstelle 5, 37, wird von der Schnittstelle der erste einzuschreibende Sektor mit den Teilbereichen SA und BE sowie die Information IN1, dass noch M-1 Sektoren einzuschreiben sind, an die Steuerung des Flash-Speichers übermittelt. Danach wird der erste einzuspeichernde Sektor mit den Teilbereichen SA und BE invertiert und als invertierte Teilbereiche SAI und BEI in den Arbeitsspeicher 7 zum Zeitpunkt t35 eingespeichert. Anschließend wird, da der erste Teilbereich SAI bereits im Block 10 programmiert ist, lediglich der zweite Teilbereich BEI als Rest des ersten einzuschreibenden Sektors S in den Block 10 programmiert, wobei kein Löschen der Speichereinheiten des Blocks 10 erforderlich ist, 39. Zum Zeitpunkt t36 ist daher der vormals gelöschte Bereich STG im Block 10 durch den invertierten zweiten Teilbereich des ersten einzuschreibenden Sektors, BEI ersetzt. Anschließend wird der zweite einzuschreibende Sektor S1N von der Schnittstelle 5 aus dem Dateisystem des Hostes 1 ausgelesen, 40 und zusammen mit der Information IN2, dass noch M-2 Sektoren einzuspeichern sind, an die Steuerung des Flash-Speichers übertragen. Nach Inversion der Daten des Sektors S1N, 31 wird dieser Sektor als invertierter Sektor S1NI in den Arbeitsspeicher 7 zum Zeitpunkt t37 eingespeichert. Anschließend wird der zweite einzuspeichernde Sektor in invertierter Form S1NI in den vorgehaltenen gelöschten Bereich SMG des Blocks 10 programmiert. Zum Zeitpunkt t38 sind im Block 10 daher die invertierten Teilbereiche des ersten einzuschreibenden Sektors, SAI, BEI und der invertierte zweite einzuschreibende Sektor S1NI programmiert. Das Verfahren des Auslesens einzelner zu programmierender Sektoren mit der Information, wie viele Sektoren noch einzuspeichern sind, das Invertieren, Abspeichern im Arbeitsspeicher und Programmieren der mit nicht unbenutzten Daten, also Nutzdaten belegten invertierten Sektoren in den Flash-Block 10 setzt sich fort, bis der letzte einzuschreibende Sektor zu programmieren ist. In Fig. 7b ist dieser letzte Sektor S1ML ein sogenannter "leerer" Sektor, der nach Inversion, 31, zum Zeitpunkt t38 als invertierter Sektor S1 MLI im Arbeitsspeicher programmiert ist. Da der invertierte Sektor S1 MLI lediglich Daten mit dem Wert 0xFF aufweist, die dem Inhalt der gelöschten Speichereinheit S1MLG im Block 10 entsprechen, findet keine Programmierung des invertierten Sektors S1MLI in den Block 10 statt, 36. Zum Zeitpunkt t39 umfasst der Block 10 daher im Vergleich zum Zeitpunkt t33 lediglich zusätzlich den invertierten zweiten Teilbereich BEI des ersten einzuschreibenden Sektors und den invertierten zweiten einzuschreibenden Sektor S1NI. Das in den Figuren 7a und b dargestellte Ausführungsbeispiel umfasst den Fall, dass der Host ein FAT oder ein Verzeichnis in der Art aktualisieren möchte, dass Teile mit bestehenden Daten unverändert bleiben und zusätzliche Daten in bisher gelöschte Bereiche abgelegt werden. Die unverändert bleibenden Bereiche des Blocks 10 sind mit den Sektoren 1 bis S-1 und S+M bis N belegt. Der gelöschte Bereich, der mit zusätzlichen Daten belegt werden soll, ist der Bereich SMG. Da sich die bereits im Flash-Speicher 9 befindlichen Daten teilweise nicht ändern, sondern lediglich bisher gelöschte Bereiche mit neuen Daten beschrieben werden, muss der Block 10 des Flash-Speichers 9 vor dem Schreiben nicht komplett gelöscht werden. Die Daten aus dem kompletten Block 10 werden in den Arbeitsspeicher 7 geladen, die für die zu schreibenden Sektoren vom Host übertragenen Daten nach dem Invertieren im Arbeitsspeicher 7 abgelegt und nur dann in den Flash-Speicher 9 programmiert, wenn sie sich von den gelöschten Bereichen des Flash-Speichers unterscheiden. Dies trifft im Ausführungsbeispiel der Fig. 7a und 7b auf den zweiten Teil des ersten einzuschreibenden Sektors, BE, und auf den Sektor S1N als zweiten einzuschreibenden Sektor zu. Die nachfolgenden, vom Host 1 übertragenen Sektoren werden nur dann in die entsprechenden, bereits gelöschten Bereiche SMG des Flash-Speichers 9 programmiert, wenn sie Daten enthalten, die sich von unbenutzten Daten unterscheiden. Solange diese Sektoren "leer" sind, also nur Bytes mit dem Wert 0x00, werden diese Bereiche durch das Invertieren zu Bereichen, bei denen alle Bytes den Wert 0xFF enthalten, also Werte, die dem Inhalt gelöschter Bereiche im Flash-Speicher SMG entsprechen. Somit werden diese "leeren" Sektoren nicht in den Flash-Speicher programmiert. Bei dem in den Figuren 6 und 7 beschriebenen Verfahren wird nicht zwischen FAT, Verzeichnis oder Datenbereich unterschieden, sondern das Invertieren findet gleichberechtigt für sämtliche einzuschreibenden Sektoren statt. Diese Vorgehensweise hat zwar den Nachteil, dass man die Sektoren, die benutzte Werte enthalten, die sich von den unbenutzten Werten unterscheiden, "unnötig" invertiert, aber den Vorteil, dass die Steuerung des Flash-Speichers keine Information über den logischen Inhalt der einzuschreibenden Sektoren benötigt. Sofern ein Speichercontroller eine Information über den logischen Inhalt der verschiedenen Sektoren hat, kann auf ein gleichberechtigtes Invertieren aller einzuschreibenden Sektoren verzichtet werden und lediglich diejenigen Sektoren werden invertiert, deren Daten unbenutzte Werte 0, die dem hexadezimalen Wert 0x00 entsprechen, aufweisen.

Aus den Ausführungsbeispielen der Figuren 6 und 7 ergeben sich folgende Beispiele:
Bei einer Sektorgröße von 512 Byte und einer Blockgröße von 16 kB sind folgende Operationen beim Schreiben erforderlich, wobei 32 Speichereinheiten pro Block angenommen werden, die jeweils einen Sektor speichern können:
- Datei mit 4 kB entspricht 8 Sektoren (in einem Block) entspricht 1-mal Block löschen und 32 Sektoren programmieren,
- Datei mit 4 kB entspricht 8 Sektoren (in zwei Blöcken) entspricht 2-mal Block löschen und 2x32=64 Sektoren programmieren,
- Datei mit 10 kB entspricht 20 Sektoren (zwei Blöcke) entspricht 2-mal Block löschen und 2x32=64 Sektoren programmieren,
- Datei mit 16 kB entspricht 32 Sektoren (zwei Blöcke) entspricht 2-mal Block löschen und 2x32=64 Sektoren programmieren.

Wenn der Host 1 beispielsweise die Dateizuordnungstabelle FAT des Dateisystems schreibt und diese beispielsweise aus 30 Sektoren besteht, von denen 20 Sektoren keine Daten enthalten (also "leer" sind), dann müssen maximal bei Verteilung der 30 Sektoren auf 2 Blöcke 2-mal ein Block gelöscht und 2x32-20=44 Sektoren programmiert werden. Wenn der Host 1 die FAT des Dateisystems des Hostes 1 erweitert und neu schreibt mit 30 Sektoren, wobei lediglich 16 Sektoren unbenutzte Daten enthalten, also "leer" sind, dann müssen keine Blöcke gelöscht und 20-16=4 Sektoren programmiert werden.

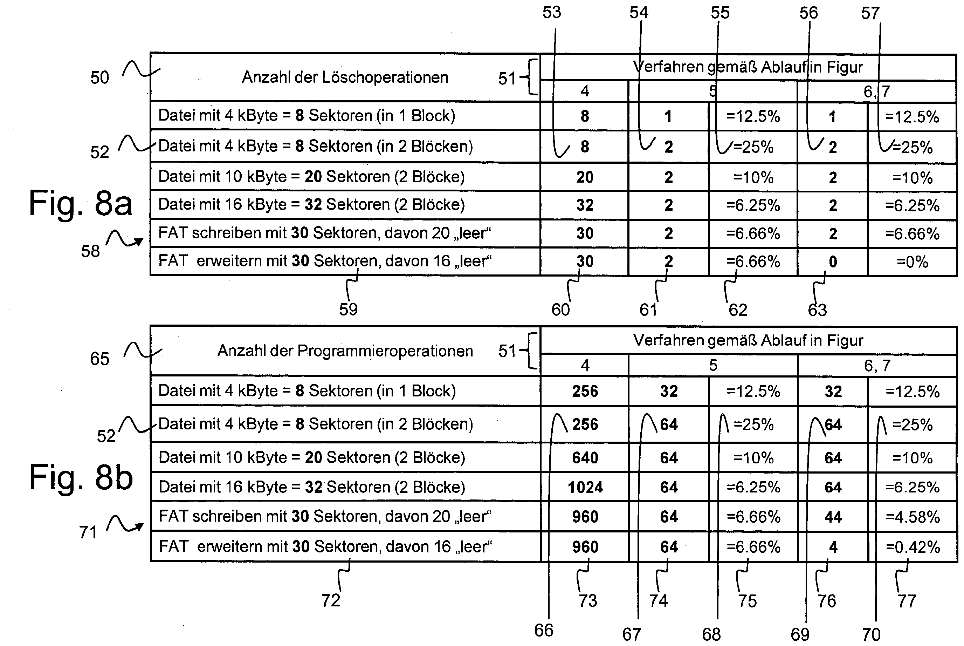

In Fig. 8a ist eine tabellarische Übersicht der Anzahl von Löschoperationen 50 für die Verfahren gemäß Ablauf in den Figuren 4 bis 7, 51, dargestellt. Angenommen ist, dass ein Block 32 Speichereinheiten aufweist, von denen jeder jeweils einen Sektor speichern kann. Daher ist angenommen, dass in einem Block 32 Sektoren speicherbar sind. Bei einer Datei von 4 kB, die 8 Sektoren entspricht und in 2 Blöcken gespeichert wird, 52, führt das herkömmliche Verfahren gemäß Ablauf in Fig. 4 zu 8 Löschoperationen, 12, in denen jeweils ein Block komplett zu löschen ist. Der Grund hierfür liegt darin, dass beim Programmieren auch nur eines einzigen Sektors im Block jeweils der gesamte Block vorab zu löschen ist. Im Gegensatz zum Ablauf gemäß Fig. 4 wird beim erfindungsgemäßen Verfahren gemäß Ablauf in den Figuren 5 bis 7 der Block, in den Daten einzuschreiben sind, jeweils nur 1-mal gelöscht. Da die 8 Sektoren in 2 Blöcke einzuschreiben sind, sind daher nur 2 Löschungen, 54, 56, kompletter Blöcke im Gegensatz zu 8 Löschungen, 53, erforderlich. Damit beträgt die Anzahl der Löschoperationen bei Einschreiben von 8 Sektoren in 2 Blöcke, 52, bei dem erfindungsgemäßen Verfahren lediglich 25% der für ein herkömmliches Verfahren erforderlichen Löschoperationen kompletter Blöcke. Im Beispiel der Beschreibung einer Dateizuordnungstabelle FAT mit 30 Sektoren in 2 Blöcke, wobei von den 30 einzuschreibenden Sektoren 20 Sektoren mit unbenutzten Daten, d. h. "leer", belegt sind, 58, ist beim herkömmlichen Verfahren gemäß Fig. 4 30-mal eine Löschung kompletter Blöcke erforderlich. Dem hingegen ist bei den Ausführungsformen der Erfindung gemäß den Figuren 5 bis 7 lediglich 2-mal eine Löschung eines kompletten Blockes erforderlich, da die 30 Sektoren in 2 unterschiedliche Blöcke eingeschrieben werden. Wenn ausgehend von dem Zustand des Flash-Speichers gemäß dem Beispiel einer Einschreibung von 30 Sektoren in 2 Blöcke, wobei 20 Sektoren unbenutzte Daten enthalten, 58, die FAT erweitert werden soll mit 30 Sektoren, von denen 16 unbenutzte Daten tragen, d. h. "leer" sind, 59, ergibt sich für das herkömmliche Verfahren gemäß Fig. 4 wiederum eine 30-fache Löschung kompletter Blöcke. Dem hingegen ist gemäß dem erfindungsgemäßen Verfahren, das in Fig. 5 geschildert ist, ohne Invertierung der einzuschreibenden Daten eine 2-malige Löschung kompletter Blöcke, 61, erforderlich, was einem Anteil von 6,66% von Löschungen gegenüber der Anzahl von Löschungen bei dem herkömmlichen Verfahren gemäß Fig. 4 entspricht, 62. Da bei dem erfindungsgemäßen Verfahren gemäß den Figuren 6 und 7, bei denen die einzuschreibenden Daten vor Programmierung in den Flash-Speicher invertiert werden, lediglich 4 Sektoren zu speichern sind im Flash-Speicher, die Nutzdaten enthalten, entfällt bei Inversion der einzuschreibenden Daten jede Löschung vorhandener Blöcke, 0.

In Fig. 8b ist eine tabellarische Übersicht der Anzahl von Programmieroperationen von Daten im Arbeitsspeicher 7 in den Block 10 des Flash-Speichers 9, 65, in Abhängigkeit der Verfahren gemäß Ablauf in den Figuren 4 bis 7, 51 dargestellt. Die Programmieroperation entspricht hierbei den Schritten 14 in den Figuren 4a und 4b und den Schritten 22, 24, 26 in den Figuren 5a und 5b. Weiter entsprechen die Programmieroperationen jeweils dem Schritt 32 in Fig. 6a und den Schritten 38, 41 in Fig. 7a. Bei dem hinsichtlich der Fig. 8a diskutierten Beispiel von einer Datei mit 4 kB, die 8 Sektoren entspricht, und die in 2 Blöcke eingeschrieben werden soll, 52, ergibt sich bei der Annahme, dass in einen Block, wie in Fig. 8a beschrieben, 32 Sektoren eingeschrieben werden können, eine Anzahl von 256 Programmieroperationen, 66 für das herkömmliche Verfahren gemäß Fig. 4. Da bei dem herkömmlichen Verfahren für jeden Sektor alle 32 Speichereinheiten gelöscht werden müssen, sind 8x32 = 256 Programmieroperationen erforderlich. Im Gegensatz hierzu wird beim erfindungsgemäßen Verfahren gemäß Fig. 5 bis 7 lediglich 64 Programmieroperationen, 67, 69, die dadurch entstehen, dass jeder der 2 zu beschreibenden Blöcke 1-mal komplett, d. h. 32-mal programmiert werden muss. Hieraus ergibt sich, wie bei der Anzahl der Löschoperationen, auch für die Anzahl der Programmieroperationen ein Faktor von einem Viertel bei dem erfindungsgemäßen Verfahren gemäß den Figuren 5 bis 7 gegenüber dem herkömmlichen Verfahren gemäß Fig. 4, 70 (25%). Im Fall eines Einschreibens einer Dateizuordnungstabelle FAT mit 30 Sektoren in 2 Blöcke, wobei von den 30 Sektoren 20 Sektoren ungenutzte Daten umfassen, 71, ergibt sich für das herkömmliche Verfahren gemäß Fig. 4 eine Anzahl von 960 Programmieroperationen (30-mal sind jeweils 32 Sektoren zu programmieren). Im Gegensatz zum herkömmlichen Verfahren ist bei dem erfindungsgemäßen Verfahren gemäß Fig. 5 ohne Invertierung der einzuschreibenden Daten lediglich eine Anzahl von 64 Programmieroperationen erforderlich (jeder der 2 beschriebenen Blöcke ist komplett, d. h. für jeweils 32 Sektoren, zu programmieren). Da bei dem erfindungsgemäßen Verfahren gemäß Fig. 6 und 7, bei dem die einzuschreibenden Daten vor der Speicherung im Block 10 invertiert werden, Daten, die gleiche Werte wie gelöschte Speichereinheiten enthalten, nicht programmiert werden, werden in diesem Falle anstelle der 64 Programmieroperationen gemäß dem Verfahren in Fig. 5 lediglich 40 Programmieroperationen (64-20=44) benötigt. Wenn nun ausgehend von dem Zustand des Flash-Speichers bei einer geschriebenen Dateizuordnungstabelle mit 30 Sektoren in 2 Blöcke, wobei von den 30 Sektoren 20 Sektoren unbenutzte Daten beinhalten, diese Dateizuordnungstabelle erweitert werden soll mit 30 Sektoren, von denen 16 Sektoren unbenutzte Daten aufweisen, 72, ergibt sich für das herkömmliche Verfahren gemäß Fig. 4 wiederum eine Anzahl von 960 Programmieroperationen, 73. Ohne Invertierung der Daten ist bei dem erfindungsgemäßen Verfahren gemäß Fig. 5 eine Anzahl von 64 Programmieroperationen erforderlich (74). 64 Programmieroperationen gegenüber 960 Programmieroperationen gemäß dem Verfahren in Fig. 4 entspricht einem Anteil von 6,66%, 75. Eine noch größere Verringerung der Programmieroperation lässt sich gegenüber dem in Fig. 4 dargestellten herkömmlichen Verfahren mit dem erfindungsgemäßen Verfahren der Figuren 6 und 7 erzielen. Da von den 30 einzuschreibenden Sektoren 16 Sektoren unbenutzte Daten führen und 20 Sektoren im Block 10 als gelöschte Speichereinheiten vorliegen, von denen 16 nach der Erweiterung der Dateizuordnungstabelle als gelöschte Speichereinheiten verbleiben, sind lediglich 4 der gelöschten Speichereinheiten mit Daten, die sich von unbenutzten Daten unterscheiden, zu programmieren, 76. Dies entspricht einem Anteil gegenüber dem herkömmlichen Verfahren von 0,42% an erforderlichen Programmieroperationen.

Die unter Bezug auf die dargestellten Ausführungsformen beschriebenen Merkmale der Erfindung, wie z. B. die Inversion der zu schreibenden Daten, 31, in den FIG. 6a, 6b, 7a, und 7b oder das Programmieren von lediglich einem Teil eines Sektors in einer Speichereinheit, 38, in Fig. 7a, können auch bei anderen Ausführungsformen der Erfindung, z.B. der in Fig. 5a und/oder Fig. 5b, vorhanden sein, außer wenn es anders angegeben ist oder sich aus technischen Gründen von selbst verbietet.

Zusammenfassend wird mit dem erfindungsgemäßen Verfahren und dem Computerprogrammprodukt zum Ausführen des erfindungsgemäßen Verfahrens ausgenutzt, dass auch ohne einen Speichercontroller der Steuerung des Flash-Speichers eine Information über die Menge der in den Flash-Speicher einzuschreibenden Daten vorliegt. Mit der Information der Menge der einzuschreibenden Daten können die für das Einschreiben der Daten erforderlichen Speichereinheiten als gelöschte Einheiten bis zum Einschreiben der Daten vorgehalten werden, so dass Löschoperationen kompletter Blöcke vermieden werden können. Weiterhin wird mit dem erfindungsgemäßen Verfahren ausgenutzt, dass gängige Dateisysteme FAT/FAT32, ungenutzte Bereiche der einzuschreibenden Sektoren mit dem gleichen Wert führen, der nach Inversion der Werte der unbenutzten Bereiche dem Wert gelöschter, nicht beschriebener Speicherzellen eines Blocks entspricht. Daher kann bei Einschreiben von Sektoren, die unbenutzte Daten führen, auf eine Programmierung dieser ungenutzten Daten nach deren Inversion in den Flash-Speicher verzichtet werden. Auf diese Weise lässt sich die Anzahl der erforderlichen Lösch- und Programmieroperationen reduzieren, wodurch sich die Geschwindigkeit für das Schreiben von Daten auf Flash-Speicher als auch die Lebensdauer der Flash-Speicher erhöht.

## Patentansprüche

1. Verfahren zur Steuerung eines Flash-Speichers (9), der von einem Kommunikationsgerät (2) eines Benutzers, das an einen Host (1) anschließbar ist, umfasst ist und zur Massenspeicherung mit zu speichernden Daten (SS1, SSN, SS1N, SA, BE, S1N, S1ML) beschrieben wird, bei dem
- der Flash-Speicher (9) in Blöcke (10), die jeweils Speichereinheiten (S1-SN) umfassen, unterteilt ist,
- eine beschriebene Speichereinheit (SS1) erneut beschreibbar ist, wenn vor dem Beschreiben der Speichereinheit (SS1) sämtliche Speichereinheiten (S1, S2, SS1, SN) des Blocks (10) der zu beschreibenden Speichereinheit (SS1) gelöscht werden,
**dadurch gekennzeichnet, dass**
- gelöschte und nicht wieder beschriebene Speichereinheiten des Flash-Speichers (9) einen Wert 0xFF aufweisen,
- wobei das Kommunikationsgerät (2) über eine Schnittstelle (5) an den Host (1) angeschlossen ist und von dem Kommunikationsgerät (2) eine Information (IN1, IN2) über die Anzahl von aufeinander folgenden zu beschreibenden Speichereinheiten, in die zu übertragende Daten geschrieben werden sollen, als Informationen über die Menge der von dem Host (1) an den Flash-Speicher (9) zu übertragenden Daten aus der Schnittstelle (5) abgerufen und zur Steuerung des Flash-Speichers (9) ausgewertet wird,
- wobei der Flash-Speicher (9) weiterhin derart gesteuert wird, dass er die Werte der Daten des Flash-Speichers (9) mit denen der zu schreibenden Daten vergleicht, basierend auf einer Unterscheidung, ob sich der Wert eines jeden Bytes der zu schreibenden Daten von dem Wert eines jeden Bytes der zu beschreibenden gelöschten Speichereinheiten unterscheidet,
- wobei der Flash-Speicher (9) derart gesteuert wird, dass im Falle, dass sich die zu schreibenden Daten von den Werten der einzelnen Bytes der Daten der gelöschten Speichereinheiten unterscheiden, keine erneute Löschung der Speichereinheiten durchgeführt wird,
- wobei der Flash-Speicher (9) derart gesteuert wird, dass zumindest ein Teil von zu beschreibenden Speichereinheiten (S1-SN), deren Daten (SG, SS1N, SAI, BEI, S1MLG) nach dem Beschreiben im Vergleich zu vor dem Beschreiben unverändert sind, weder gelöscht noch beschrieben wird,
- wobei bei den zu beschreibenden gelöschten Speichereinheiten oder einem Teil hiervon eine erneute Löschung unterbleibt und lediglich Daten eingeschrieben werden, die sich von den Daten gelöschter Speichereinheiten oder einem Teil hiervon unterscheiden, und
- wobei die Information (IN1, IN2) unabhängig von einem Zwischenspeicher oder einem Speichercontroller in der Schnittstelle (5) zu dem Host (1) vorliegt.

2. Verfahren nach Anspruch 1, bei dem für einen Vergleich der Werte der Daten des Flash-Speichers (9) mit denen der zuschreibenden Daten (SSN, SS1N, SSMN, SA, S1L, S1N, S1ML) ausreichend ist, dass der Inhalt der Daten (SSN, SS1N, SSMN, SA, S1L, S1N, S1ML) auf der Byteebene oder auf der Bitebene untersucht wird.

3. Verfahren nach Anspruch 2, bei dem der Steuerung des Flash-Speichers (9) lediglich vorliegt, ob zu schreibende Daten (SSN, SS1N, SSMN, SA, S1L, S1N, S1ML) Bytes mit jeweils einem Wert ungleich "0xFF" aufweisen, wobei diese Information durch Analyse der Werte auf der Bitebene und/oder auf der Byteebene erfolgt.

4. Verfahren nach einem der Ansprüche 1 bis 3, bei dem die Informationen (IN1, IN2) über die von dem Host (1) an den Flash-Speicher (9) zu übertragenden Daten (SS1N, SSMN, S1L, S1N, S1ML) in einem Massenspeicherprotokoll, insbesondere in einem USB-Massenspeicherprotokoll, vorliegen.

5. Verfahren nach einem der Ansprüche 1 bis 4, bei dem allein aus der Anzahl von Speichereinheiten als Menge von Sektoren, die in den Flash Speicher (9) eingeschrieben werden sollen, auf die Anzahl aufeinanderfolgender zu beschreibender Speichereinheiten geschlossen wird, da die Größe des Dateninhaltes eines Sektors des Hostes (1) in der Schnittstelle (5) zur Übertragung der Daten bekannt ist.

6. Verfahren nach einem der Ansprüche 1 bis 5, bei dem neben einem Inhalt (SSN, SS1N) der ersten zu beschreibenden Speichereinheit die Information (IN1, IN2) als Zusatzinformation über eine Anzahl der der ersten Speichereinheit (SSN, SS1N) nachfolgenden Speichereinheiten von der Schnittstelle (5) bereitgestellt wird.

7. Verfahren nach einem der Ansprüche 1 bis 6, bei dem von dem Host (1) übertragene in zumindest eine Speichereinheit (S1-SN) eines Blocks (10) des Flash-Speichers (9) zu schreibende Daten (SA, BE, S1ML) vor dem Beschreiben der zumindest einen Speichereinheit (S1, SN) invertiert werden.

8. Verfahren nach Anspruch 7, bei dem bei mehreren zu beschreibenden Speichereinheiten (SMG), in die die zu übertragenden Daten (SA, BE, S1ML) geschrieben werden sollen, die Daten (SA, BE, S1ML) für sämtliche Speichereinheiten (SMG) invertiert werden.

9. Verfahren nach Anspruch 8, bei dem für benutzte Bereiche eines Dateisystems, die nicht den Wert "0x00" aufweisen, invertiert werden, um die Daten dieser Bereiche beim Auslesen aus dem Flash-Speicher verwenden zu können, wobei der Flash-Speicher (9) keine Information über den logischen Inhalt der zu speichernden Daten benötigt.

10. Verfahren nach einem der Ansprüche 7 bis 9, bei dem ungenutzte Bytes von Daten (U, S1ML) des Hostes (1), die in den Flash-Speicher (9) geschrieben werden sollen, bei Ablage in der Schnittstelle (5) den hexadezimalen Wert 0x00 aufweisen, nach dem Invertieren den hexadezimalen Wert 0xFF eines gelöschten Bytes im Flash-Speicher (9) aufweisen, und anstelle eines Schreibens des hexadezimalen Wertes 0xFF in eine gelöschte Speichereinheit (STG, S1MLG) die gelöschte Speichereinheit (STG, S1MLG) ohne erneute Löschung im gelöschten Zustand (SG) gehalten wird.

11. Verfahren nach einem der Ansprüche 1 bis 10, bei dem der Flash-Speicher (9) bei einer Verwendung des Flash-Speichers (9) als Nebenaggregat des Kommunikationsgerätes (2) gesteuert wird, wobei ein Zwischenspeicher und/oder Speichercontroller mit einer Übersetzungstabelle nicht erforderlich ist.

12. Computerprogrammprodukt zum Ausführen des Verfahrens nach einem der Ansprüche 1 bis 11.

13. Kommunikationsgerät (2), auf dem das Computerprogrammprodukt nach Anspruch 12 installiert ist.

14. Kommunikationsgerät (2) nach Anspruch 13, wobei das Kommunikationsgerät (2) als Endgerät, beispielsweise in Form eines Mobiltelefons, Tablet-PCs, PDAs, oder Smartphones, oder als Server, beispielsweise in Form eines Desktop-PCs oder Laptops, ausgeführt ist.

## Claims

1. A method for controlling a flash memory (9) comprised by a user's communication device (2) connectable to a host (1) and written for mass storage with data to be stored (SS1, SSN, SS1N, SA, BE, S1N, S1ML), wherein
- the flash memory (9) is divided into blocks (10) each comprising memory units (S1-SN)
- a written memory unit (SS1) is rewritable if all memory units (S1, S2, SS1, SN) of the block (10) of the memory unit (SS1) to be written are deleted before the memory unit (SS1) is written,
**characterized in that**
- deleted and not rewritten memory units of the flash memory (9) have a value 0xFF,
- wherein the communication device (2) is connected to the host (1) via an interface (5) and information (IN1, IN2) about the number of successive memory units to be written, into which data to be transmitted is to be written, is retrieved from the interface (5) by the communication device (2) as information about the amount of data to be transmitted from the host (1) to the flash memory (9) and is evaluated for controlling the flash memory (9),
- wherein the flash memory (9) is further controlled to compare the values of the data of the flash memory (9) with those of the data to be written, based on a differentiation of whether the value of each byte of the data to be written is different from the value of each byte of the deleted memory units to be written,
- wherein the flash memory (9) is controlled such that in the event that the data to be written differs from the values of the single bytes of the data of the deleted memory units, no new deletion of the memory units is performed,
- wherein the flash memory (9) is controlled in such a way that at least a part of memory units (S1-SN) to be written, whose data (SG, SS1N, SAI, BEI, S1MLG) are unchanged after writing compared to before writing, is neither deleted nor written,
- wherein the deleted memory units or part thereof to be written are not deleted again and only data different from the data of deleted memory units or part thereof are written, and
- wherein the information (IN1, IN2) is present in the interface (5) to the host (1) independently of a cache or a memory controller.

2. The method according to claim 1, wherein for a comparison of the values of the data of the flash memory (9) with those of the data to be written (SSN, SS1N, SSMN, SA, S1L, S1N, S1ML), it is sufficient that the content of the data (SSN, SS1N, SSMN, SA, S1L, S1N, S1ML) is examined at the byte level or at the bit level.

3. Method according to claim 2, in which the control of the flash memory (9) only knows whether data (SSN, SS1N, SSMN, SA, S1L, S1N, S1ML) to be written have bytes each with a value not equal to "0xFF", wherein this information is obtained by analysing the values at the bit level and/or at the byte level.

4. Method according to any of the claims 1 to 3, in which the information (IN1, IN2) about the data (SS1N, SSMN, S1L, S1N, S1ML) to be transmitted from the host (1) to the flash memory (9) is present in a mass storage protocol, in particular in a USB mass storage protocol.

5. Method according to any of the claims 1 to 4, in which the number of memory units to be written into the flash memory (9) is derived solely from the number of memory units as a set of sectors, since the size of the data content of a sector of the host (1) in the interface (5) for transmitting the data is known.

6. Method according to any of the claims 1 to 5, in which, in addition to a content (SSN, SS1N) of the first memory unit to be written, the information (IN1, IN2) is provided by the interface (5) as additional information about a number of the memory units following the first memory unit (SSN, SS1N).

7. Method according to any of the claims 1 to 6, in which data (SA, BE, S1ML) to be written into at least one memory unit (S1-SN) of a block (10) of the flash memory (9) transmitted by the host (1) is inverted before writing to the at least one memory unit (S1, SN).

8. Method according to claim 7, in which, in the case of a plurality of memory units (SMG) to be written and into which the data (SA, BE, S1ML) to be transmitted is to be written, the data (SA, BE, S1ML) for all the memory units (SMG) is inverted.

9. Method according to claim 8, in which for used areas of a file system which do not have the value "0x00" are inverted in order to be able to use the data of these areas when reading out from the flash memory, wherein the flash memory (9) does not require any information about the logical content of the data to be stored.

10. Method according to any of the claims 7 to 9, wherein unused bytes of data (U, S1ML) of the host (1) to be written into the flash memory (9) have the hexadecimal value 0x00 when stored in the interface (5), have the hexadecimal value 0xFF of a deleted byte in the flash memory (9) after inversion, and instead of writing the hexadecimal value 0xFF into a deleted memory unit (STG, S1MLG), the deleted memory unit (STG, S1MLG) is kept in the deleted state (SG) without being deleted again.

11. Method according to any of the claims 1 to 10, wherein the flash memory (9) is controlled when the flash memory (9) is used as a secondary unit of the communication device (2), wherein a cache and/or memory controller with a translation table is not required.

12. Computer program product for carrying out the method of any of the claims 1 to 11.

13. Communication device (2), on which the computer program product according to claim 12 is installed.

14. Communication device (2) according to claim 13, wherein the communication device (2) is configured as a terminal device, for example, in the form of a mobile phone, tablet PC, PDA or smartphone, or as a server, for example, in the form of a desktop PC or laptop.

## Revendications

1. Procédé de commande d'une mémoire flash (9) comprise par un dispositif de communication (2) d'un utilisateur qui peut être connecté à un hôte (1) et sur laquelle sont écrites des données (SS1, SSN, SS1N, SA, BE, S1N, S1ML) à stocker pour un stockage de masse, dans lequel
- la mémoire flash (9) est divisée en blocs (10) comprenant chacun des unités de mémoire (S1-SN),
- une unité de mémoire écrite (SS1) peut être réécrite si, avant l'écriture de l'unité de mémoire (SS1), toutes les unités de mémoire (S1, S2, SS1, SN) du bloc (10) de l'unité de mémoire (SS1) destinées à être écrites sont effacées,
**caractérisé en ce que**
- les unités de mémoire effacées et non réécrites de la mémoire flash (9) ont une valeur de 0xFF,
- le dispositif de communication (2) étant raccordé à l'hôte (1) via une interface (5) et une information (IN1, IN2) sur le nombre d'unités de mémoire successives destinées à être écrites, dans lesquelles des données à transmettre doivent être écrites, étant extraite de l'interface (5) par le dispositif de communication (2) en tant qu'informations sur la quantité de données à transmettre par l'hôte (1) à la mémoire flash (9) et exploitée pour commander la mémoire flash (9),
- la mémoire flash (9) étant de plus commandée de manière à comparer les valeurs des données de la mémoire flash (9) avec celles des données à écrire, sur la base d'une distiction si la valeur de chaque octet des données à écrire est différente de la valeur de chaque octet des unités de mémoire effacées destinées à être écrites,
- la mémoire flash (9) étant commandée de telle sorte que, dans le cas où les données destinées à être écrites diffèrent des valeurs des différents octets des données des unités de mémoire effacées, les unités de mémoire ne sont pas de nouveau effacées,
- la mémoire flash (9) étant commandée de telle sorte qu'au moins une partie des unités de mémoire (S1-SN) destinées à être écrites, dont les données (SG, SS1N, SAI, BEI, S1MLG) sont inchangées après l'écriture en comparaison à avant l'écriture, n'est ni effacée ni écrite,
- un nouvel effacement n'ayant pas lieu pour les unités de mémoire effacées destinées à être écrites ou une partie de celles-ci et seules des données qui diffèrent des données d'unités de mémoire effacées ou d'une partie de celles-ci étant inscrites, et
- l'information (IN1, IN2) étant présente indépendamment d'une mémoire temporaire ou d'un contrôleur de mémoire dans l'interface (5) avec l'hôte (1).

2. Procédé selon la revendication 1, dans lequel, pour une comparaison des valeurs des données de la mémoire flash (9) avec celles des données destinées à être inscrites (SSN, SS1N, SSMN, SA, S1L, S1N, S1ML), il suffit que le contenu des données (SSN, SS1N, SSMN, SA, S1L, S1N, S1ML) soit examiné au niveau de l'octet ou au niveau du bit.

3. Procédé selon la revendication 2, dans lequel la commande de la mémoire flash (9) dispose uniquement du fait de savoir si des données destinées à être inscrites (SSN, SS1N, SSMN, SA, S1L, S1N, S1ML) comportent des octets ayant chacun une valeur différente de "0xFF", cette information étant obtenue par analyse des valeurs au niveau du bit et/ou de l'octet.

4. Procédé selon une des revendications 1 à 3, dans lequel les informations (IN1, IN2) relatives aux données (SS1N, SSMN, S1L, S1N, S1ML) à transmettre par l'hôte (1) à la mémoire flash (9) sont présentes dans un protocole de stockage de masse, notamment dans un protocole de stockage de masse USB.

5. Procédé selon une des revendications 1 à 4, dans lequel est déduit du seul nombre d'unités de mémoire en tant qu'ensemble de secteurs à inscrire dans la mémoire flash (9), le nombre d'unités de mémoire successives destinées à être écrites, du fait que la taille du contenu de données d'un secteur de l'hôte (1) dans l'interface (5) de transmission des données est connue.

6. Procédé selon une des revendications 1 à 5, dans lequel, outre un contenu (SSN, SS1N) de la première unité de mémoire destinées à être écrite, l'information (IN1, IN2) est fournie par l'interface (5) en tant qu'information supplémentaire sur un nombre d'unités de mémoire succédant à la première unité de mémoire (SSN, SS1N).

7. Procédé selon une des revendications 1 à 6, dans lequel des données (SA, BE, S1ML) transmises par l'hôte (1) et devant être écrites dans au moins une unité de mémoire (S1-SN) d'un bloc (10) de la mémoire flash (9) sont inversées avant l'écriture dans ladite au moins une unité de mémoire (S1, SN).

8. Procédé selon la revendication 7, dans lequel, dans le cas de plusieurs unités de mémoire (SMG) destinées à être écrites, dans lesquelles les données (SA, BE, S1ML) à transmettre doivent être écrites, les données (SA, BE, S1ML) sont inversées pour toutes les unités de mémoire (SMG).

9. Procédé selon la revendication 8, dans lequel pour des zones utilisées d'un système de fichiers qui ne présentent pas la valeur "0x00" sont inversées afin de pouvoir utiliser les données de ces zones lors de la lecture dans la mémoire flash, la mémoire flash (9) ne nécessitant aucune information sur le contenu logique des données à mémoriser.

10. Procédé selon une des revendications 7 à 9, dans lequel des octets inutilisés de données (U, S1ML) de l'hôte (1) qui doivent être écrites dans la mémoire flash (9) présentent la valeur hexadécimale 0x00 lorsqu'ils sont déposés dans l'interface (5), après inversion, présentent la valeur hexadécimale 0xFF d'un octet effacé dans la mémoire flash (9), et au lieu d'une écriture de la valeur hexadécimale 0xFF dans une unité de mémoire effacée (STG, S1MLG), l'unité de mémoire effacée (STG, S1MLG) est maintenue dans l'état effacé (SG) sans être à nouveau effacée.

11. Procédé selon une des revendications 1 à 10, dans lequel la mémoire flash (9) est commandée lors d'une utilisation de la mémoire flash (9) en tant qu'unité auxiliaire du dispositif de communication (2), une mémoire intermédiaire et/ou un contrôleur de mémoire avec une table de conversion n'étant pas nécessaire.

12. Produit programme d'ordinateur pour la réalisation du procédé selon une des revendications 1 à 11.

13. Dispositif de communication (2) sur lequel est installé le produit programme d'ordinateur selon la revendication 12.

14. Dispositif de communication (2) selon la revendication 13, dans lequel le dispositif de communication (2) est conçu comme un terminal, par exemple sous la forme d'un téléphone mobile, d'une tablette numérique, d'un PDA ou d'un smartphone, ou comme un serveur, par exemple sous la forme d'un PC de bureau ou d'un ordinateur portable.
